# EUROPEAN PATENT SPECIFICATION

(11) **EP 4 071 493 B1**
(45) Date of publication and mention of the grant of the patent: **28.02.2024**
(21) Application number: 22167026.8
(22) Date of filing: 06.04.2022
(51) Int. Cl.: G01R 33/30, G01R 33/44

(54) **SHUTTLE ASSEMBLY FOR 2FNMR**
SHUTTLE-ANORDNUNG FÜR 2FNMR
ENSEMBLE NAVETTE POUR 2FNMR

(30) Priority: 08.04.2021 EP 21167449
(43) Date of publication of application: 12.10.2022
(73) Proprietor: Bruker BioSpin GmbH, 76275 Ettlingen (DE)
(72) Inventor: Aders, Philipp, 76131 Karlsruhe (DE); Tilch, Andreas, 76137 Karlsruhe (DE); Marquardsen, Thorsten, 76137 Karlsruhe (DE); Tyburn, Jean-Max, 67160 Wissembourg (DE); Sommer, Jonas, 76131 Karlsruhe (DE)
(74) Representative: Kohler Schmid Möbus Patentanwälte

(56) References cited:
- WO-A1-2019/089961
- HALL ANDREW M R ET AL: "A temperature-controlled sample shuttle for field-cycling NMR", JOURNAL OF MAGNETIC RESONANCE, ACADEMIC PRESS, ORLANDO, FL, US, vol. 317, 27 June 2020 (2020-06-27), XP086236113, ISSN: 1090-7807, DOI: 10.1016/J.JMR.2020.106778 [retrieved on 2020-06-27]
- TOMHON PATRICK ET AL: "Automated pneumatic shuttle for magnetic field cycling and parahydrogen hyperpolarized multidimensional NMR", JOURNAL OF MAGNETIC RESONANCE, ACADEMIC PRESS, ORLANDO, FL, US, vol. 312, 4 February 2020 (2020-02-04), XP086081428, ISSN: 1090-7807, DOI: 10.1016/J.JMR.2020.106700 [retrieved on 2020-02-04]
- CHING-YU CHOU ET AL: "A compact high-speed mechanical sample shuttle for field-dependent high-resolution solution NMR", JOURNAL OF MAGNETIC RESONANCE, vol. 214, 10 December 2011 (2011-12-10), pages 302-308, XP028437255, ISSN: 1090-7807, DOI: 10.1016/J.JMR.2011.12.001 [retrieved on 2011-12-10]

## Description

The invention relates to a shuttle assembly designed and adapted for being arranged inside a guide tube of an NMR spectrometer with at least two coaxially arranged NMR magnet systems and with a system for shuttling an NMR sample in the guide tube between the NMR magnet systems, the guide tube being comprised in a transfer device and configured to be positioned in a central bore of the coaxial magnet systems, wherein the shuttle assembly comprises a sample container for containing the NMR sample, wherein the shuttle assembly has a piston design for enabling movement along the common axis of the coaxial magnet systems under the influence of gas pressure generated by a pneumatic pressurizing arrangement being part of the transfer device, and wherein the shuttle assembly comprises a plug positioned in the sample container for limiting the liquid NMR sample volume in the sample container to the active volume area of the magnet systems in an operational state of the spectrometer.

Such shuttle assembly is known from Reference [8].

A transfer device comprising a cable pull system and a shuttle assembly as defined above is disclosed in applicant's earlier European Patent Application 21 167 449 (= Reference [0]), the priority of which is claimed for the present application and which has not yet been published at the date of this present application.

### Technical background of the invention

In general, the present invention relates to the technical field of magnetic resonance. Nuclear magnetic resonance (="NMR") spectroscopy is a powerful tool in instrumental chemical analysis and a commercially widespread method for analyzing and characterizing the chemical composition of substances. In NMR experiments, a sample is exposed to a strong static magnetic field, which interacts with spins of nuclei contained in the sample. Radio frequency (="RF") pulses are sent into the sample for manipulating the spins, and the sample's reaction, i.e. RF signals (also called "NMR signals") are measured. The sample's reaction depends on the environment of the nuclei in the sample, in particular bonding electrons. Accordingly, information about the chemical structure of the sample can be obtained by analysing the NMR signals measured.

Improvements of NMR methods like field-cycling allow exploiting interaction of nuclear spins with magnetic fields of different strengths, by means of which more spectroscopic information about the sample becomes accessible. Field-cycling techniques in NMR have been applied on various field dependent studies. The main idea is to measure the relaxation in the frequency basis. Its applications include material science, such as polymer dynamics, and structural biology, such as membrane dynamics and protein dynamics, and relaxation measurements on contrast agent in MRI field, etc.

In particular, in two-field NMR (="2F-NMR") experiments, nuclear spins may be exposed to and manipulated by means of RF pulses at two different magnetic field strengths. This allows obtaining additional spectroscopic information about the sample, in particular dynamic information or an additional measurement dimension, which may be used to increase resolution, in particular to identify maxima in spectra more reliably.

At a first working volume equipped with the first NMR probe, a first field strength ("high field") with a high homogeneity is present, allowing in particular a strong initial polarization and a signal detection with high resolution and high sensitivity. Further, nuclear spin manipulations may be done at the first working volume. At a second working volume equipped with the second NMR probe, a second field strength ("low field") with an at least fairly good homogeneity is present, which also allows nuclear spin manipulations , in particular band-selective manipulations of spins.

For numerous nuclear spin systems, the coupling properties and/or the relaxation times depend on the magnetic field strength present. Accordingly, since there are two different field strengths available, a 2F-NMR apparatus may perform experiments, which make use of the different coupling properties and/or relaxation times in the same single measurement.

This provides additional information about the sample in spectroscopy applications. In particular, dynamic information (movement information) about nuclei in the sample or molecules containing said nuclei may be obtained. Thus, an additional dimension of NMR measurement of the sample becomes available. This additional dimension is based on a different second field strength and therefore on a different physical behaviour, as compared to the physical behaviour at the first field strength. In other words, the development of a spin system in the sample is different at the first and second field strength.

### Special prior art

EP 3 081 954 B1 (= Reference [2]) in detail describes 2F-NMR measurements involving a sample in a first working volume of a highly homogeneous magnetic field with a first field strength and transferring the sample to a second working volume with a magnetic field having lower homogeneity at a second field strength. A sample carrier is provided for transporting the sample between the first working volume and the second working volume by means of a device for transporting the sample comprising a straight tubular guide in which the sample carrier may move, and further two pieces of auxiliary tubing for applying gas pressure at the opposing ends of the tubular guide. By means of pressure differences between the ends of the tubular guide, the sample carrier may be accelerated within the tubular guide. The gas pressure is controlled via shuttle controller. By means of position sensors, an arrival of the sample carrier at a desired working volume may be verified.

A scientific article (= Reference [3]) by Alfred G. Redfield ("Shuttling device for high-resolution measurements of relaxation and related phenomena in solution at low field, using a shared commercial 500MHz NMR instrument" Magn. Reson. Chem. 2003; 41: 753-768) discloses an apparatus usable in unmodified spectrometer and probe without much modification. A pneumatic glass shuttle tube, 22mm inside diameter, held in an aluminum support tube, is temporarily inserted in place of the upper tube that is supplied by the manufacturer to be inserted into the top of the magnet. A standard thin-walled NMR tube is connected to a plastic piston shuttle that is moved up or down inside the shuttle tube, by low vacuum or pressure applied from the top. A shock absorber is attached to the bottom end of the stop tube, to stop the sample's upward travel at a point where the field has the desired value for the relaxation determination, and an identical shock absorber is built into the top of the shuttle tube bottom mount. When a sample has to be removed to be replaced by another, or in preparation for removing the apparatus from the spectrometer, the stop tube is removed, and the shuttle, with the attached sample tube, is sucked up to the top with a simple vacuum fitting (not shown).The low value of magnetic field, where the relaxation process measured occurs, is determined by a movable mechanical stop whose position is changed manually between runs. The downward path is initiated by a short higher-pressure pulse, followed by a long lower pressure interval. The round trip time limit is about 0,2s, suitable for relaxation rate measurements in the range up to about 10s⁻¹.

A later article (= Reference [4]) by Alfred G. Redfield ("High-resolution NMR field-cycling device for full-range relaxation and structural studies of biopolymers on a shared commercial instrument" J. Biomol NMR (2012) 52:159-177) describes a shuttle device for NMR spectrometers. The shuttler installed on top of the 500MHz commercial instrument at Brandies University. The top of one of the four vertical legs of the shuttler support frame is visible in front. The frame of the linear motor is C-clamped to one of the top rails of the frame. Directly between the two timing belts is the extender, containing the short upper section of the glass shuttle tube. Passing through the hula bearing from the bottom, a short section of the push rod is visible, connected at its top to the black plastic cross-piece, which is clamped to the two timing belts. The linear motor assembly is based on a servomotor and shaft driving two timing-belt pulleys that drive two side-by side timing belts, which in turn pass over two smaller upper pulleys about 1,4m above the motor shaft (not visible). The plastic cross-piece is clamped onto and between the two belts, and the rotary motor is programmed by the microprocessor to move it at high speed, up to 10m/s. The bottom section of the vertical post, that supports the upper pulleys nearly 1,3m above, is visible behind the nearest timing belt. The upper of the two Helmholtz coils is visible just below the two rails, covered with white plastic, that support the linear motor assembly.

US 9,696,391 B2 (= Reference [5]) discloses a shuttle device to shuttle an NMR sample from a first high field volume to a second volume. The shuttling device includes: (i) A motor assembly, which is fixed on the horizontal mounting board and (ii) a guiding rail assembly attached to the motor assembly from below of a horizontal mounting board. (iii) The shuttle carries the sample tube to slide up or down along the designated path on a guiding rail assembly. This shutting apparatus, when in use, is mounted on top of a superconducting magnet, by resting the horizontal mounting board on top of the magnet. The guiding rail assembly, the shuttle and the sample are all inside of the magnet bore.

EP 2 610 631 B1 (= Reference [6]) describes a device and a method for Dynamic Nuclear Polarization (="DNP") enhanced NMR. The device comprises a high field superconductive polarization magnet inside a cryostat and an auxiliary low field magnet, which is located above the polarization magnet and has variable field strength, which can be regulated from 0mT up to 10mT or more. A movable sample positioning device with attached sample holder is used to position the sample inside the cryostat by means for instance of a pneumatic actuator or electro-mechanical drive (not shown) for polarization of the nuclear spins.

US 4,859,949 A (= Reference [7]) describes a transport mechanism for samples in a clinical NMR spectrometer. A sample holder including a plurality of bores is located vertically through the holder. Further included within each bore is a ram guide channel, which maintains alignment of ram in the approximate center of each bore. The support surface includes an opening formed therethrough in alignment with the central bore. The opening is part of an extended channel, which maintains the ram in alignment with the central bore. The ram includes a rigid portion and a flexible portion. The flexible drive band is typically a plastic band having compressive strength for supporting the rigid ram and dimensioned to maintain the width of the rigid ram at the limit created by lateral ribs. The other end of the drive band is affixed to a drive wheel, which is rotated for controlling movement and position of the entire ram. The angular position of the drive wheel is controlled by means of a drive belt and a stepper motor.

A temperature-controlled sample shuttle for field-cycling NMR is known from a scientific article by Andrew M.R. Hall et al, "A temperature-controlled sample shuttle for field-cycling NMR", Journal of Magnetic Resonance 317 (2020) 106778 (= Reference [1]). This document describes in its chapter 3 a shuttle system comprising a cord drive system with a winch and a stepper motor to move a sample shuttle between variable magnetic fields. The shuttle is guided inside a guide tube. A counter pressure, which keeps the cord under tension, is not provided and hence a high-speed transfer of the shuttle is not possible in this known system.

The present invention specifically relates to a nuclear magnetic resonance spectrometer suitable for performing field cycling techniques such as relaxometry or two-field NMR, having at least two coaxially arranged NMR magnet systems generating different magnetic fields, and having a transfer device for reciprocating an NMR sample container / NMR sample vessel between the NMR magnet systems, the transfer device comprising a guide tube positioned in a central bore of the coaxial magnet systems, a shuttle assembly arranged in a guide tube for securely holding and moving the NMR sample container within the guide tube. As described in Reference [0] already cited above, the drive system for moving the shuttle assembly with the sample container includes a cable pull and compressed air is applied to the shuttle as a counterforce.

This cable pull device is especially designed to ensure fast movement of NMR sample tubes between two different magnetic fields for relaxometry, where the transfer of the sample between the magnet systems must take place in the millisecond range. In this type of fast transfer, compressed air is applied to the sample tube in a tube to enable the downward movement and a cable pull is used to provide the counterforce for the upward pulling movement of the sample tube. For this reason, the transfer arrangement of Reference [0] comprises a shuttle arrangement disposed inside a guide tube to securely hold the NMR sample tube, wherein the shuttle arrangement has a piston-like design that holds the cable pull and is movable under the influence of the compressed air. The present invention relates to a shuttle system for NMR tubes that are moved by said push-pull drive system vertically within the magnet by a cable pull system.

### Objects of the invention

An NMR sample tube should oscillate in the shortest possible time between two spatially separated magnetic fields of different field strengths to enable relaxometry and 2F-NMR measurements. The technical challenge is to develop a compact mechanism which can be integrated into an NMR spectrometer and which is able to move the sample container precisely in milliseconds at high speed without negatively affecting the measurement by shocks, vibrations, heat input or contamination by foreign objects.

In 2F-NMR experiments, two magnets are placed on top of each other and the sample container oscillates between their respective magnetic centers. The sample tube is immersed in the lower (HighField) probe head, while its so-called "shuttle" (slide in the linear guide) comes to a standstill above the probe head. For excitation in the upper (low-field) probe head, the shuttle first passes through a controlled field area before the sample tube reaches its low field measurement position.

In order to achieve the highest possible filling factor, the linear guide must not take up more radial installation space than the sample container and the materials used must not impair the measurement. In order for the device to be set up in common laboratories, the room height must be taken into account during construction, which means that the shuttle system, when installed, may only slightly increase the total height of the spectrometer.

Taking this into consideration, it is an object of the present invention to provide a compact shuttle system, which can easily be integrated in an NMR spectrometer in a space-saving manner and which allows to oscillate the NMR sample container within a very short time period of less than 100ms very precisely between two adjustable or selectable measuring positions of different magnetic field strengths in order to allow for relaxometric and 2F-NMR measurements without negatively affecting or impairing the measurements by mechanical shocks, vibrations, heat input or contamination by debris or other foreign matter, in particular during standstill phases.

Accordingly, the shuttle assembly according to the present invention should be designed in such a way that the cable pull can be attached to the shuttle and the geometrical design is cylindrical so that it can be moved by the compressed air like a piston in the guide tube. Hence, it is an object of the present invention to provide a shuttle device with a suspension for NMR tubes (=sample containers), which allows the transport by means of a cable pull between several magnetic fields.

Furthermore, the sample container should be rotatable in the suspension in the measuring position. In order to prevent the simultaneous rotation of the cable pull, a device should be adapted to decouple the suspension of the cable pull from the attachment of the sample container or a retainer of the sample container.

### Brief description of the invention

This object is achieved, in accordance with the present invention and in a surprisingly simple and effective way, by a shuttle assembly which can be integrated in a generic 2F-NMR spectrometer having the features defined in the first paragraph of the top page, wherein the plug has a central bore in axial direction for filling NMR sample material into the sample container, preferably by means of an injection needle, the bore being closed by a rod, which is at least partly extending into the sample container with its lower end during operation of the spectrometer.

The rod is directly or indirectly mechanically connected with the locking piece, not necessarily with the pulling drive, during operation of the spectrometer. The positioning rod fixes the plug in its target position and closes the bore. It is also needed to pull the plug out of the sample containers. At the upper end, the positioning rod is clamped into a closure, e.g. with the help of a grub screw, to prevent it from oscillating and thus hitting the sample container, which would generate disturbing vibration.

The transfer system according to the invention can easily be integrated into a commercial NMR spectrometer in a space-saving manner and is capable of moving an NMR sample container, which is fastened to the shuttle assembly, precisely between at least two adjustable measuring positions in less than 100ms.

In particular, the presented transfer system with the shuttle assembly allows an NMR sample container to move rapidly in a couple of milliseconds between two positions at a distance of about 1m or even more for high field NMR magnets having a longer central bore and thus a longer distance to the low field magnet positioned above. The filling factor inside the magnet bore is very low as it only uses a guide tube made of a nonmagnetic material such as glass having an inner diameter, which corresponds to the shuttle assembly plus the surrounding air gap. The whole kinematic structure is localized inside the guide tube of 3mm to 15mm in diameter.

The number of pieces and the geometry is minimalized, as it requires only a cable (preferably made of nylon) and a tube. The state-of-the-art solutions are each more space demanding.

The cable winch and the changing station, which are arranged above the NMR-magnet, have a compact geometry such that it implicates generally no inconvenience for an installation in laboratory rooms with a standard ceiling height.

The system can be adapted to existing or commercially available NMR spectrometers without any modification in the magnet bore.

The 2F-NMR spectrometer has at least two coaxially arranged NMR magnet systems. For relaxometry, the second spot is not adapted for high resolution whereas the first spot in 2F-NMR is. The second magnetic spot can be e.g. a ferromagnetic-shim, a magnetic tunnel, a permanent magnet, a cryo-magnet or a suitable electro-magnet.

The winch cord is permanently maintained under tension in each operating phase of the spectrometer, and it should not slack off for proper functionality. For example, the shuttle can be held in an uppermost position with a resilient means to be maintained under tension in the changing station even when the gas supply is turned off.

### Preferred embodiments and further developments of the invention

In straightforward embodiments of the invention, the shuttle assembly is designed as being moveable in linear directions along the common axis of the coaxial magnet systems.

Preferred embodiments of the shuttle assembly according to the invention are characterized in that the piston design comprises a guidance sleeve clasping around the sample container in circumferential direction, in particular being glued on an outer surface of the sample container, for high precision alignment of the shuttle assembly within the guide tube in an operational state of the spectrometer.

The parts of the guidance sleeves are positioned in reasonable distance with consistent ratio to the tip of the sample container with the active volume that travels unguided beyond the guide tube ending to the probe head coil.

In particular, the sleeve parts have a radial gap (≈10 µm ... 100µm) to the guide tube inner wall for shuttling without contact preventing abrasion of the sleeves and preventing stimulus for vibration of the guide tube which will lead to amplifying the vibration amplitude which will lead to a contact of the sleeve and the guide tube inner wall resulting in heavy tear and wear. Further, the guidance sleeve ensures a flow of 5 Nl/min ...25Nl/min of pressurized gas with controlled temperature for temperature control of the sample liquid.

The guidance sleeve can be improved in that it comprises an end stop part near to the tip of the sample container defining the immersion depth of the sample container in a probe head of the spectrometer, the end stop part preferably having a conical abutment surface for axial and radial coupling to an end stop with protrusion for vibration dampening.

This end stop part is the lowest part of the guide sleeve around the the sample container within the guide tube. It determines the immersion depth of the NMR sample container in the probe. In its design as a turned part, it allows fast, precise, low-cost manufacturing.

This guidance sleeve can be even further improved when it comprises a -preferably threaded- bush part near to the opening of the sample container, wherein the bush part and the end stop part having essentially the same diameter for ensuring precise guidance of the shuttle assembly within the guide tube in an operational state of the spectrometer, the bush part preferably having an internal screw thread for receiving a locking piece.

The bush part is the uppermost part of the guide sleeve. The large axial distance to the end stop ensures precise guidance and low friction on the guide tube. Preferably, it comprises an internal thread for receiving a stopper. The threaded sleeve is preferably glued to the sample container.

Preferentially, the parts of the guidance sleeve have an outer contour such that there is a tight clearance to the threaded sleeve, i.e. a small radial gap, which leads to precise guidance of the sample container, thus no tilting is possible.

In an advantageous variant, a circumferential, contoured outer surface of the guidance sleeve directed to the circumferential inner surface of the guide tube has circumferential grooves, preferably helical grooves, for spinning the sample container in a gas flow.

A further very utile variant is characterized in that the contoured circumferential outer surface of the guidance sleeve has having small pits or grooves, preferably sharp edged, in particular highly unsymmetrical pit or symmetric grooves, serving as vortex generators for providing a highly turbulent gas flow. Furthermore, these turbulence generators can be imprinted on the outer surface of the guidance sleeve. They are used for producing a chaotic turbulence of the air stream, without symmetry or periodicity. This prevents the occurrence of stable oscillatory states that cannot be terminated during operation. At the same time, it increases the shuttle's insensitivity to diameter tolerances and symmetry deviations due to manufacturing tolerances. So, the turbulent vortices serve for additionally centering the NMR sample container during the operation, because the vortex forces act radially from all sides at the same time. When non-contoured sleeves are used, the NMR sample containers have been found to oscillate or vibrate.

Particularly preferred is a variant, in which the plug has a chamfered outer surface, in particular of conical shape, at its lower end directing to the tip of the sample container during operation of the spectrometer, and a circumferential notch on its outer surface taking effect as a bubble catcher during operation of the spectrometer.

Said circumferential notch catches gas bubbles otherwise causing a disturbance factor during measurement. The large chamfer at the bottom causes the resulting gas bubbles to move outward and upward.

Further, the plug can have grooves for receiving gaskets, in particular O-rings for sealing functions.

In especially preferred embodiments of the invention, a retainer, in particular of spheroidal shape, is attached to a locking piece, the retainer also being attached to the drive system. The locking piece preferably has closable openings.

The locking piece is screwed into the upper threaded sleeve. It encloses the knot from the rope and thus establishes the connection from the shuttle to the rope and motor.

The spherical retainer closes the openings in the locking piece to the rope receptacle and thus ensures an even flow around the shuttle.

In other embodiments it can be the retainer that is enclosing the knot from the rope.

Advantageous variants of these embodiments are characterized in that the drive system comprises a winch cord being attached to the retainer of the shuttle assembly, and that the retainer and the locking piece being slidably attached to each other for forming a decoupling mechanism for rotatably decoupling the sample container from the winch cord in an operational state.

With this rotatable suspension, the shuttle assembly can be rotated in the measurement position relative to the cable pull. Thus, the cable pull is attached to a suspension that does not rotate itself. Rather it is rotatably decoupled from the rest of the assembly so that the NMR sample container can rotate in the suspension without twisting the cable pull.

These variants can be further improved in that the decoupling mechanism comprises nano- or microbearings placed between the locking piece, which is firmly attached to the sample container, and the non-rotating retainer on which the winch cord is suspended, the nano- or microbearings being designed to allow for rotation of the sample container, whereby the winch cord is not drilled. These bearings allow rotation of the NMR sample container, because the frictional resistance is lower than with plain bearings. Besides other advantages, this design allows the use of a thinner cable pull.

In preferred further developments of these variants, the decoupling mechanism of the retainer comprises a braking system with a spring biased element connected to clamping arms, wherein in a first operational state, when the opposing forces of the gas pressure generated by the pneumatic pressurizing arrangement and the pulling force generated by the pulling drive are substantially equal, the spring biased element causes the clamping arms to be folded in, whereas in a second operational state, when the gas pressure is lowered, the clamping arms are unfolded under the spring bias of element and pressed against the guide tube.

In addition to the sealing plug closing the NMR sample container, these versions comprise a two-part retainer device in which a first component can be pressurized with compressed air and a second component comprises the cable suspension. Both components are movably connected to each other by a spring. The second component comprises the clamping arms which are movable on a hinge and which, when a certain pressure is applied, move correspondingly inwards into the transfer position, in which the shuttle can move translationally in the guiding tube, or outwards into the clamping position, in which the arms are firmly clamped to the guide tube and the NMR sample container is rotatably mounted.

The present invention also concerns a NMR spectrometer according to claim 9, containing a shuttle assembly according to the invention, a transfer device, a guide tube and a drive system as described above.

The transfer device comprises a pulling drive and a winch cord being attached to the drive system on one side and to the shuttle assembly on the other side, wherein the pulling drive of the drive system preferably comprises a cable winch, which is equipped with a rotating mechanism, and that the transfer device comprises a gas-tight body above the shuttle assembly and a pneumatic pressurizing arrangement with an entry for pressurized gas arranged on the gas-tight body for maintaining the winch cord under tension.

In particularly preferred embodiments of the invention, an air gap is provided between the shuttle piston and the inner wall of the guide tube. The airgap provides a gas cushion for the shuttle for a quicker movement inside the guide tube without any friction.

The filling factor inside the magnet bore is very low as it only uses a glass tube having an inner diameter, which corresponds to the shuttle piston design plus the surrounding air gap. Under these conditions, especially for the low field probe in 2-field NMR, the filling coefficient of the RF coil for transmission and reception is maximized. The useful RF power is reduced whilst increasing the sensitivity at low fields.

The air gap may amount from 10µm and 100µm. Depending on the applied gas pressure, the air gap allows the passage of gas, which is preferably adjusted to a chosen temperature for the sample. The gas flow through the air gap amounts to at least 5 l/min up to 25 l/min, preferably at least 10 l/min. The tempered gas stream flows through the air gap between the guide tube and the shuttle piston design and reaches the NMR sample container. The sample container can take over the temperature of the gas stream. In NMR applications, a constant, stable and accurate temperature is required, regardless of the field plate in which the measurement is made. In this particular case of relaxometry NMR or 2FNMR, these conditions are reached and there will be no influence on the temperature at high field.

In another advantageous embodiment, the pulling drive of the drive system is equipped with a rotating mechanism, preferably driven by a servo motor or a stepper motor. The rotating mechanism allows a compact embodiment of the drive system. A cable winch can be designed to fit above an NMR spectrometer not protruding too much beyond the spectrometer.

Stepper motors or servomotors can accelerate quickly and in particular, these motors are adjustable to a certain number of steps. The position of the sample in the guide tube is well known because each of the sample positions in the sample tube corresponds to a position of the stepper motor, so the number of steps are determined before use. The obtained positioning is better than 0,1mm. The Z position of the sample corresponds to a stepper motor encoding.

In a preferred further development of this embodiment, the servo motor or stepper motor is calibrated for the number of steps being performed between two measuring positions within the NMR magnet systems, the distance between the upper and the lower measuring position being recorded by determining the appropriate number of steps. The positioning in the measuring magnetic field for relaxometry or 2FNMR is then accurate.

A preferred embodiment of the invention is characterized in that the pulling drive comprises a cable winch. As mentioned above, the cable winch allows a compact design. Often the spectrometers are high extending up to the laboratory ceiling, so a compact design is necessary. The main advantage is a silent solution that limits the risk of wear and tear and limits the diffusion of friction residue in the NMR measuring chambers.

It is conceivable to use a swinging arm, an independent axle or a cam instead of a cable winch, but they are less preferred.

In an advantageous embodiment, an end stop being vibration damping in high field position comprises an abutment surface between the shuttle and a protrusion at the end of the guide tube. The damping helps to cushion the hard stop so that the NMR sample tube (container) does not detach or displace from the shuttle assembly. It is also a double check of the correct positioning of the sample in the high-resolution probe.

Preferably, the abutment surface is chamfered. The chamfer allows the centralizing of the shuttle assembly with the NMR sample container inside the field of view of the spectrometer.

The guide tube and the drive system may be mounted together to form an essentially gas-tight body. It might, however, be easier, not to pressurize the drive system. So, in simpler embodiments, there is just a small gas stream arranged from the changing station to the drive system to exhaust gas via the drive system to avoid any heating of the pressurized gas by the motor.

Advantageous is a further embodiment, wherein a gas-tight exchange station comprises a window, a movable sleeve or a door and the guide tube or an extension of the guide tube having an opening to access the shuttle assembly and the NMR sample container.

In another preferred embodiment, the guide tube ends in front of the changing station and the shuttle assembly abuts to a movable weight element which is pulled to an upper resilient stop. The weight element is engaged with a guide rail which is helpful to reinsert the NMR sample container into the guide tube when the cord is lowered.

Thus, an easy exchange of the sample container is facilitated. The exchange station can have a means to depressurize the chamber or to shut the pressurized gas supply before opening the exchange station by moving the sleeve or opening the door. This solution allows a fast sample exchange. It also allows considering the use of a sample changer robot.

In any case, it is preferable to use the driven pressurized gas for tempering the sample at the same time. Additionally or supplementary, it is possible to use a partly permeable shuttle piston in order to direct tempering gas to the sample region.

The guide tube is not necessarily designed integrally, uniformly and/or one-pieced. In embodiments of the invention, the opening of the tube can as well be a separate part.

Preferred is a class of embodiments, which are characterized in that a detector element is arranged to measure the exact position of the shuttle assembly in the magnetic fields. Said detector element is arranged to measure the exact position of the shuttle to ensure that the sample tube is precisely positioned in the homogenous B0' field in the lower position and in the high B0" position for 2F-NMR. The detector element can be connected to an interface to the operating software. This makes it possible to measure very quickly when the shuttle is in the measurement position and the software can trigger the measurement immediately.

In this class of embodiments, the detector element may comprise a light barrier transmitting light through the guide tube, when the shuttle piston is in its lower position in the high B0 field and the high position B0" field for 2F-NMR.

Another preferred embodiment of the invention provides that the guide tube be made of nonmagnetic material. This is essential for not disturbing the magnetic field, neither in its saturation nor in its homogeneity, is that what this solution proposes.

In an advantageous further development of the transfer device, the guide tube is radially fixed by bumper fastenings or dampening brackets that constraint the maximum radial vibration amplitude to less than air gap dimension. This has also been proven for effectively reducing the abrasion of the shuttle assembly.

Further preferred is an embodiment, wherein the winch cord comprises a cord, a wire or a rope. The cord should not be flexible or elastic so that the cord responds directly to the acceleration/deceleration. Otherwise, the cycle time will be longer. Nylon is a suitable material for this purpose.

The winch cord is aligned in the center of the guide tube by a centering device, which is arranged on the upper end of the guide tube. The centering device can be combined with the weight device of the exchange station. The centering device is preferably designed with several through holes for allowing an easy flow of the pressurized gas into the guide tube and a center hole through which the winch cord is guided.

With the help of the centering device, the induced vibrations in the guide tube were significantly reduced. In addition, the abrasion on the shuttle assembly has been significantly reduced due to the fact that the shuttle is better centered.

In preferred embodiments of the invention, the diameter of the guide tube ranges from 3mm to 15mm. If the diameter is too big, the torque of the motor needs to increase a lot and the shuttling speed of the shuttle assembly will be decreased due to the mass of the NMR sample container and the force of the pressurized gas on the shuttle assembly. It is even possible to be used for very small NMR sample tubes of 3mm diameter.

The Nuclear Magnetic Resonance spectrometer according to the invention is adapted for performing field-cycling techniques including two-field NMR (="2F-NMR"), with at least two coaxially arranged NMR magnet systems for generating different magnetic fields comprising a transfer device with a shuttle assembly as described above. The NMR spectrometers known in the art are not suitable for two-field NMR measurements as the transfer between the magnet systems is generally not fast enough compared to the quick relaxation time of the spins of the nuclei.

Further advantages can be extracted from the description and the enclosed drawing. The features mentioned above and below can be used in accordance with the invention either individually or collectively in any combination. The embodiments mentioned are not to be understood as exhaustive enumeration but rather have exemplary character for the description of the invention.

### Detailed description of the invention and drawing

The invention is shown in the drawing and is explained in more detail on the basis of illustrative embodiments.

The invention is shown in the drawings:
- Fig. 1: shows a schematic vertical cross section through an NMR spectrometer with a transfer device according to the invention;
- Fig. 2: shows a schematic cut-away view of an embodiment of the exchange station in a transfer device for use with the invention;
- Fig. 3: shows in a stereoscopic partial view an embodiment of the transfer device for use with the invention with a gas-tight exchange station and a shuttle assembly therein;
- Figs. 4a-c: show -each in a partial view- schematic vertical cross sections through transfer devices with a detector element and end stop facilities for the shuttle assembly;
- Fig. 5: shows a schematic vertical cross section through a high field NMR magnet system with a guide tube, a shuttle assembly and dampening brackets of the transfer device inside the magnet bore;
- Figs. 6a-c: show -each in a partial view- schematic vertical cross sections through embodiments of the exchange station
(a) in an upper position of the shuttle for opening,
(b) in an intermediate position of the shuttle, and
(c) in a closed position;
- Figs. 7a-c: show each schematic vertical cross sections through an embodiment of the shuttle assembly according to the invention
(a) with all important parts separately,
(b) with the parts of (a) in the assembled condition, and
(c) an enhanced partial view of the lower portion of (b);
- Figs. 8a-d: show each a schematic view of an important part of the shuttle assembly according to Fig. 7b, namely
(a) a vertical cross section of a plug for limiting the liquid NMR sample volume in the sample container and taking effect as a bubble catcher,
(b) the plug of (a) in a side view,
(c) a locking piece in a vertical cross section, and
(d) a retainer for being attached to the locking piece of (c) also in a vertical cross section;

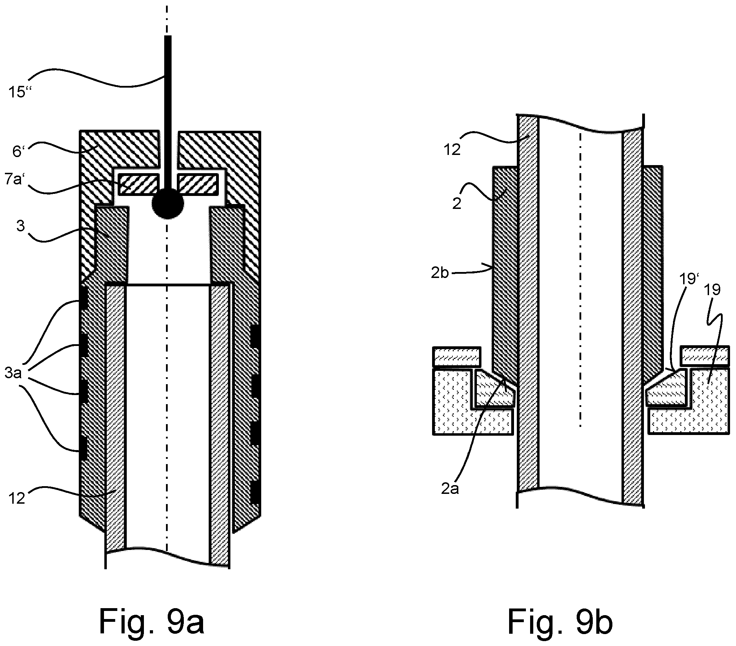

- Fig. 9a: shows a schematic vertical cross section through the upper part of an embodiment of the shuttle assembly according to the invention with a rotatable suspension for NMR measuring tubes comprising a sliding washer;
- Fig. 9b: shows a schematic vertical cross section through the lower part of an embodiment of the shuttle assembly with a rotational bearing system comprising an end stop in form of a sliding cone;

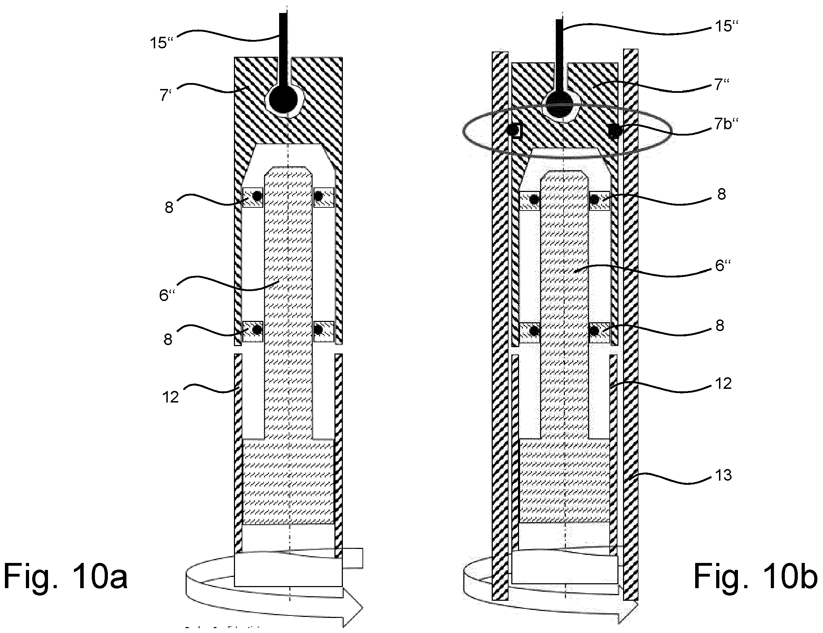

- Fig. 10a: shows a schematic vertical cross section through the upper part of another embodiment of a suspension for the shuttle assembly comprising nano- or microbearings between a plug and a non-rotation retainer on which a cable is suspended, facilitating rotation of the NMR tube and decouple the suspension from the rotary motion;
- Fig. 10b: shows the embodiment of Fig. 10a with an additional O-ring rotational brake;

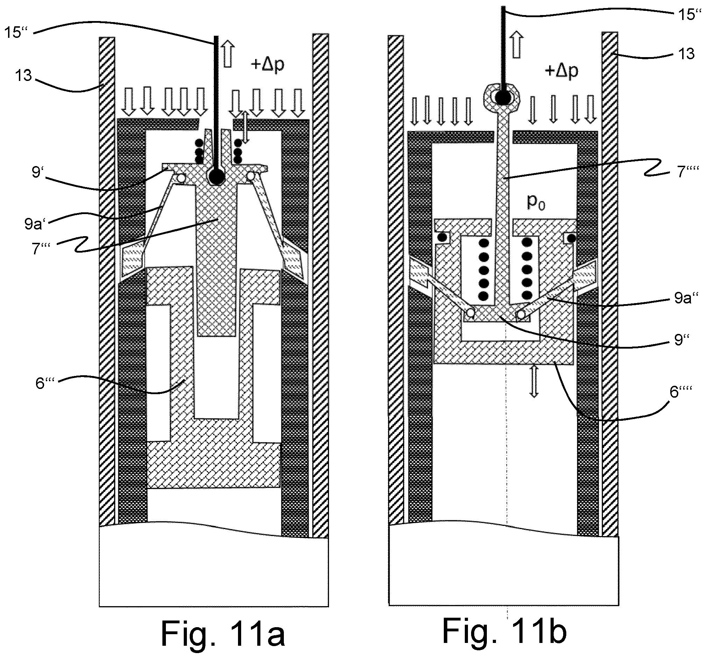

- Fig. 11a: shows a schematic vertical cross section through the upper part of another embodiment of a suspension for the shuttle assembly comprising a spring mechanism with downward pivotable clamping arms;
- Fig. 11b: shows an embodiment with upward pivotable clamping arms;

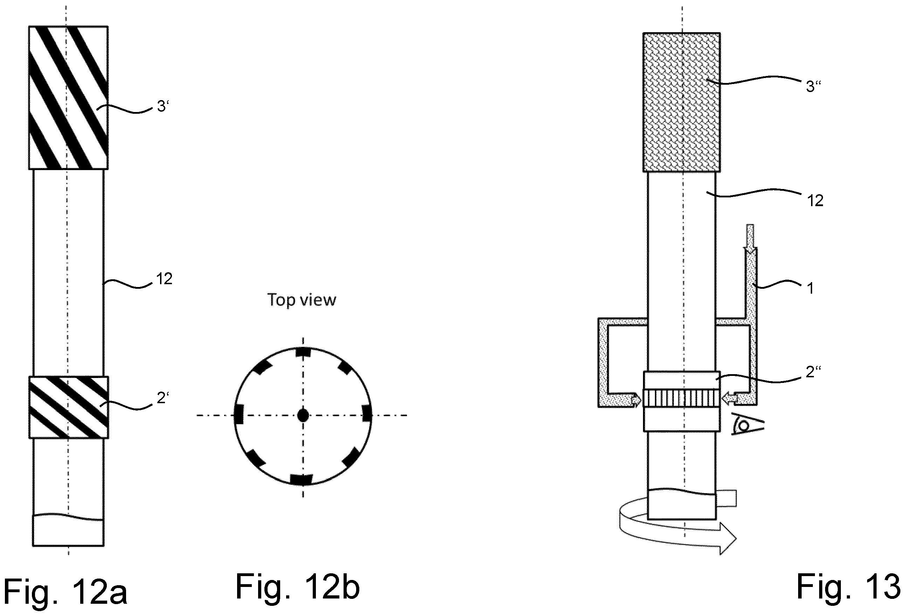

- Fig. 12a: shows a schematic side view on an embodiment of the shuttle assembly comprising sleeves with helical thread profile for passing the compressed air;
- Fig. 12b: shows a top view on the embodiment of Fig. 12a; and
- Fig. 13: shows a schematic side view on an embodiment of the shuttle assembly comprising a lower sleeve with a serrated profile and a feed channel and radially arranged nozzle for compressed gas.

The transfer device according to Reference [0] is especially adapted for a rapid transfer of an NMR sample between two magnet systems in a push-pull manner using a cable and compressed gas as counterforce.

This device is particularly useful in relaxometry, where the measurement times are quite short, so the usual rotation of the NMR tube in the magnetic field during the measurement is not necessary. For spectroscopic measurements with higher resolution, on the other hand, such as in two-field- NMR, it is necessary to rotate the NMR tube during the measurement to average out magnetic field inhomogeneities.

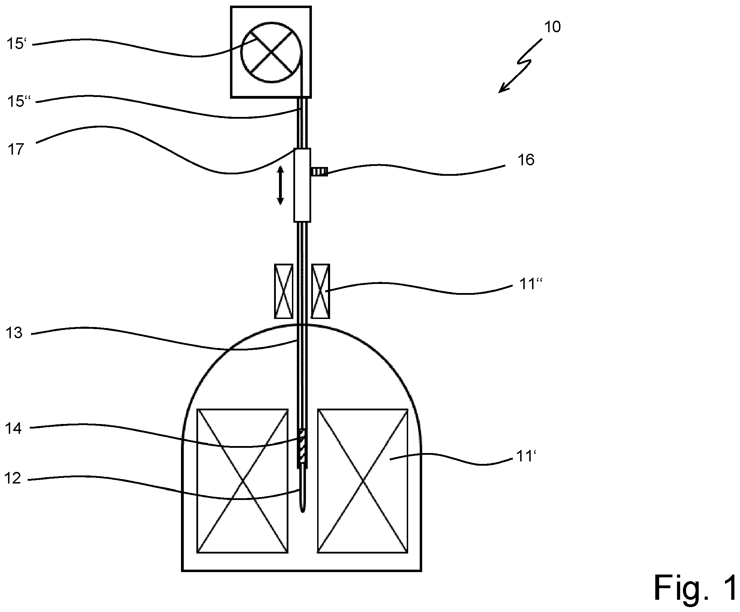

**Fig. 1** schematically depicts a transfer device for shuttling a Nuclear Magnetic Resonance (=NMR) **sample container 12** between at least two coaxially arranged NMR magnet systems 11'; 11" of an **NMR spectrometer 10,** in particular a **high-field NMR magnet system11'** and a **low-field NMR magnet system 11".** The transfer device comprises a **guide tube 13** positioned in a central bore of the coaxial magnet systems 11'; 11", a **shuttle assembly 14** being arranged inside the guide tube 13 for securely holding and shuttling the NMR sample container 12 and a drive system comprising a **pulling drive 15'** and a **winch cord 15"** being attached to the drive system on one side and to the shuttle assembly 14 on the other side, such that the shuttle assembly 14 can travel inside the guide tube 13 between the coaxial magnet systems 11'; 11".

The pulling drive 15' of the drive system may comprise a cable winch, which is equipped with a rotating mechanism. The rotating mechanism can be driven by a servo motor or a stepper motor (not shown in the drawings). The servo motor or stepper motor can be calibrated for the number of steps being performed between two measuring positions within the NMR magnet systems 11'; 11", the distance between the upper and the lower measuring position being recorded by determining the appropriate number of steps.

The transfer device according to the invention is characterized by a pneumatic pressurizing arrangement with an **entry 16 for pressurized gas** arranged on a **gas-tight body 17** above the shuttle assembly 14 being adapted to maintain the winch cord 15" under tension, and by a shuttle assembly 14 comprising a piston design being moveable along the common axis of the coaxial magnet systems 11'; 11" under the influence of the pressure.

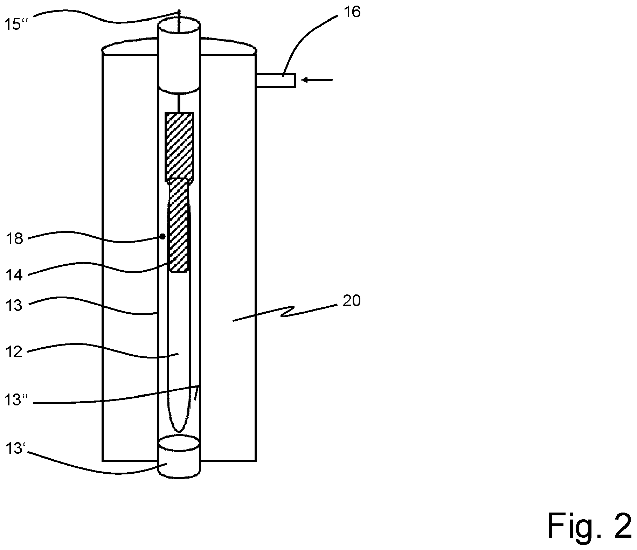

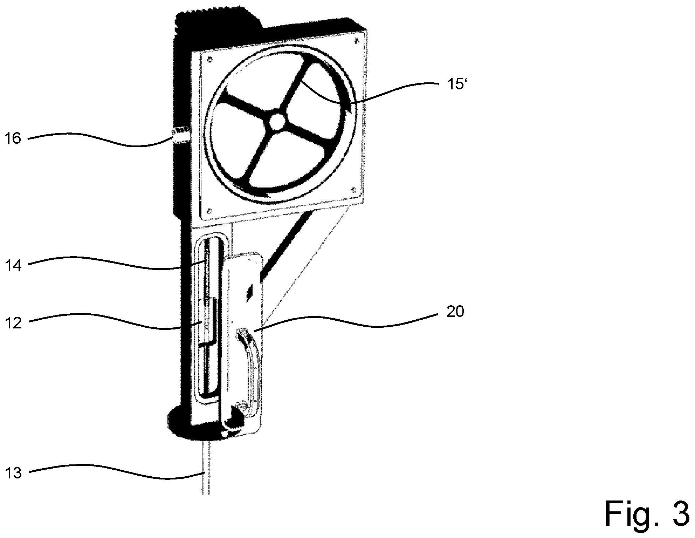

In Fig. 1, the whole shuttle assembly 14 with the guide tube 13 and a drive mechanism is shown schematically being implemented in a two-field NMR device. The shuttle is attached by the winch cord 15" and it can be moved between a high field position, a low field position and a changing position where the shuttle is located inside a **gas-tight exchange station 20** as shown in Figs. 2 and 3. Pressurized gas is fed via the changing station to keep the winch cord under tension.

The shuttle assembly 14 comprises a piston fitting into the guide tube 13 with an outer circumference so that it can move in it without friction. The friction between the shuttle and the guide tube is reduced by the fact, that the compressed air can flow circumferentially past the shuttle, thus creating an air cushion between the guide tube 13 and the central bore of the coaxial magnet systems 11'; 11". In the present design, the distance to the wall of the guide tube is only 10 to 50 µm so that a flow of approximately 10 standard liters per minute is created between the wall of the guide tube 13 and the shuttle when a pressure of 3 to 6 bar is applied.

This gas flow is used in preferred embodiments to temper the sample in the sample container 12. The gas is therefore preset to a desired temperature.

As shown in the schematic cut-away view of **Fig. 2** depicting the gas-tight exchange station 20 being part of the transfer device according to the invention, an air gap 18 is provided between the shuttle piston 14 and the **circumferential inner surface 13"** (= inner wall) of the guide tube 13. The air gap 18 may amounts from 10µm and 50µm.

Preferably, the pressure gas connection with the entry 16 is located at the non-movable component of the exchange station 20, whereby the gas flow can also be opened and closed there, either manually with a gas cock, or with a mechanically releasable shutter valve.

Usually, the guide tube 13 is made of glass. As indicated in Fig. 2, the guide tube 13 in its lower part may comprise a **drilled hole 13'** in a cylindrical aluminum component that also can contain a gas inlet.

F**ig. 3** shows an embodiment of a transfer device with the pulling drive 15' of the drive system in the shape of a cable winch, the exchange station 20 and the shuttle assembly 14 therein. Being integrated into an NMR spectrometer 10 in a space-saving manner, the transfer device is capable of moving an NMR sample tube 12, which is fastened to the shuttle, precisely between at least two adjustable measuring positions in less than 100ms.

The basic idea was to design the shuttle as a pneumatic piston, which is guided in a tube made of dielectric material, so that it is pushed down with compressed air with the movement being controlled by a cable winch. As alternative embodiments (not shown here), a swing-arm or a cam can be used instead of a winch. The winch cord 15" is always kept under tension by the constantly applied gas pressure, allowing the shuttle to be precisely positioned with the pulling drive 15'. Since the moving parts have relatively low masses, significantly higher accelerations and speeds can be achieved than with belt-driven or rail-guided systems. Due to the central introduction of force by the cord pull or compressed air, no bearing forces are generated, so the system is subject to little wear and thus has a long service life. The shuttle is designed to fit in the tube with a narrow gap between the shuttle and the guide tube 13 thus allowing the formation of an air bearing or air cushion. The airflow between the shuttle/NMR-tube and the wall of the guide tube 13 is well calibrated and it can be used for tempering the sample.

The presented shuttle system allows a sample container 12 to move rapidly in a couple of milliseconds between two position. The filling factor inside the magnet bore is very low as it only uses a glass tube having an inner diameter which corresponds to the sample container 12 plus the surrounding air gap 18. The whole kinematic structure is localized inside the guide tube 13 of about 10mm in diameter.

The number of pieces and the geometry is minimalized as it requires only a (nylon) cable and a tube. The state-of-the-art solutions are more space demanding.

The pulling drive 15' and the changing station 20, which are arranged above the magnet systems 11'; 11", have a compact geometry such that there is generally no inconvenience for an installation in laboratories with a standard ceiling height.

The system can easily be adapted to existing NMR spectrometers without any modification in the magnet bore.

Preferably, the NMR sample container 12 is maintained by the shuttle by force fitting elements such as a series of O-rings, which are positioned in a gap of the shuttle. The shuttle is designed to fit into the opening of a sample container 12. The friction force between the shuttle and the sample container 12 surfaces are designed to be sufficient for the high acceleration and deceleration of the sample container 12.

The piston is guided and sealed by a high-precision borosilicate glass tube which runs from the changing station (air lock) on the magnet to just above the high-field sample head in the magnet, where it ends in a centering end stop. Especially for use in 2F-NMR, the use of a quartz glass tube as a guide element is advantageous compared to a conventional linear slide, since its symmetrical geometry and material have a comparatively small effect on the measurement in the upper (low-field) sample head.

The shuttle is adapted to move in the guide tube 13 between an upper (low field) and a lower (high field) measuring position. For that the connection to the pressurized air or gas is arranged above the piston in its upper position and arranged such that the cord which is attached to the shuttle is kept under tension. For sealing effectiveness, the transfer device comprises pressurized system components with sealing carried out on the drive shaft. The connection to the pressurized gas is either at the gas tight cable winch or at the changing station 20. The advantage of these gas entry arrangements is that the box of the cable winch and the changing station 20 serves as a gas chamber providing a reservoir of pressurized gas which limits variations in pressure and gas temperature (= buffer volume). However, the motor can produce heat which could change the gas temperature. So the entry via the box of the cable winch is less preferred.

The changing station 20 is arranged between the guide tube 13 and the pulling drive 15', above the upper measuring position. To change the sample container 12, the changing station 20 is depressurized, e.g. by closing a valve for gas inlet, and the shuttle is driven to an uppermost position. In this position, the changing station can be opened by the user to change the NMR sample container 12. In a preferred embodiment, the changing station 20 is surrounded by a generally cylindrical jacket, which is movable from a first position in which the changing station is closed and gas tight, to a second position in which the changing station is open and the shuttle with the sample container 12 is accessible to the user such that the sample container 12 can be changed. The shuttle exchange is executed in unpressurized condition with the cable / rope pretension is provided by a spring-loaded mechanism.

The system is supplied with pressurized gas (e.g. compressed air connection 6bar, even better: nitrogen) and with power from the socket (220V). The motor control preferably of a servo motor communicates with the spectrometer software ("TopSpin") via a data interface (e.g. CAN-Bus, Ethernet, USB). The software connection and the motor control correspond to the state of the art and comparable systems are used to control belt-driven shuttle systems.

In some embodiments, the pressurized gas is heated or cooled to the desired measurement temperature. In this way the sample temperature can be adjusted by using leaking piston drive gas flow. To make the tempering more efficient, the piston can be provided with through holes thus increasing the gas flow around the NMR sample container 12.

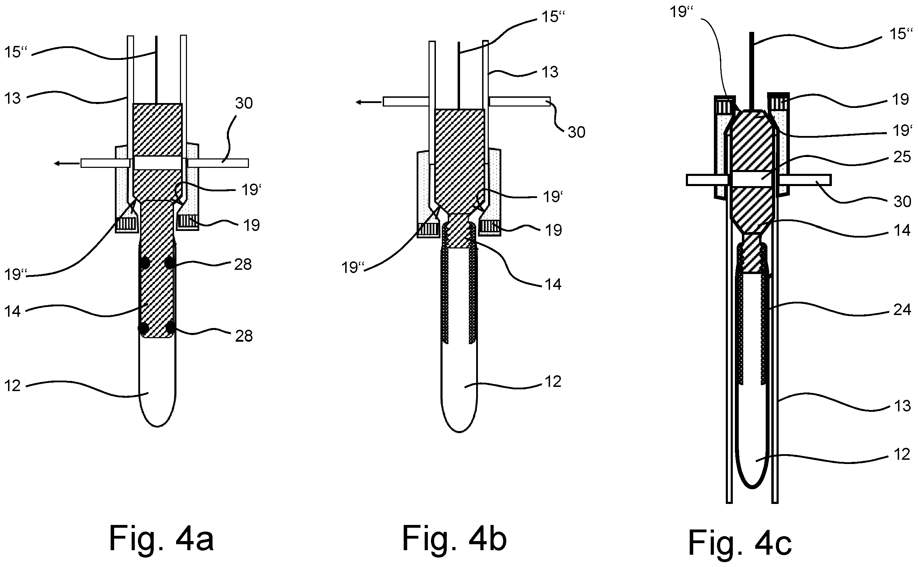

In **Figures 4a to 4c****,** various examples of a transfer device are shown, each having **end stop facilities 19** for the shuttle assembly 14.

The end stop 19 is vibration damping in high field position and comprises **abutment surfaces 19', 19"** between the shuttle assembly 14 and a protrusion at the end of the guide tube 13. The abutment surfaces 19', 19" are chamfered for centering the NMR sample container 12 in the field of view when the shuttle assembly 14 is in its end stop position.

The abutment surface 19' arranged in the guide tube 13 is helpful to precisely position the shuttle assembly 14. By using a stepper motor or a servo motor the distance between the upper and the lower measuring positions can be recorded or determined to adjust the number of steps that the motor performs between both positions.

As can be seen in the Figures 4a-c, the shuttle assembly 14 is provided with several projections that serve as abutment surfaces to position the shuttle in an exact end stop position in the high field range of the magnet. As a counterpart, a holder with a circumferential, preferably beveled end stop is arranged below the guide tube 13, on which the shuttle rests when the NMR sample container 12 is in the measuring position. The holder is fixedly arranged at the lower end of the guide tube 13. The NMR sample container 12 with the sample protrudes from the holder into the homogeneous area of the magnet (FOV).

The shuttle is designed in such a way that it fits into a standardized NMR sample container 12 with a diameter of 5mm, with -at least two- **O-rings 28** to provide a tight compression fitting to the NMR sample container 12. Alternatively, **holding elements 24** can be attached or glued to the NMR sample container 12, the holding elements 24 comprising for example a screw thread to which the shuttle can be screwed.

A **detector element 30** is arranged to measure the exact end stop position of the shuttle assembly 14 in the magnetic fields, to ensure that the sample container 12 is precisely positioned in the homogenous B0 field in the lower position. A light barrier or a photo sensor transmitting light through the guide tube 13, when the shuttle assembly 14 is in its correct end stop position in the B0 field.

Furthermore, the shuttle assembly 14 may have a transparent area (e.g. the **window 25** as depicted in Fig. 4c) through which the end position is detected by means of light guides positioned in the holder. The light guides are connected to a photo sensor. This sensor technology using photo sensors makes it possible to trigger the measurement via an interface in the operating software as soon as the shuttle has arrived at the measuring position. This feature allows the execution of very fast measuring cycles.

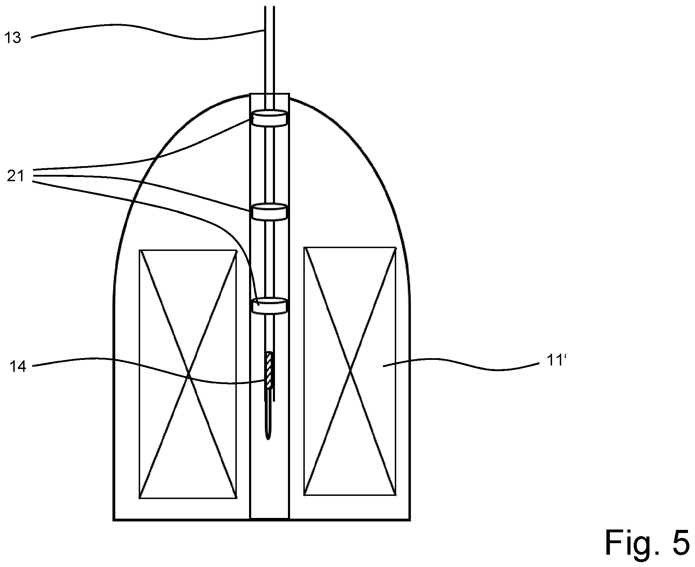

The schematic vertical cross section through a high field NMR magnet system 11' shown in **Fig. 5** illustrates essential parts of the transfer device according to the invention, which are partly arranged inside the magnet bore.

The guide tube 13 is radially fixed by bumper fastenings or **dampening brackets 21,** which retain the guide tube inside the magnet bore and reduce significantly the vibrations and consequently also the friction and the wear of the system. Thereby the maximum radial vibration amplitude can be constrained to less than the air gap dimension.

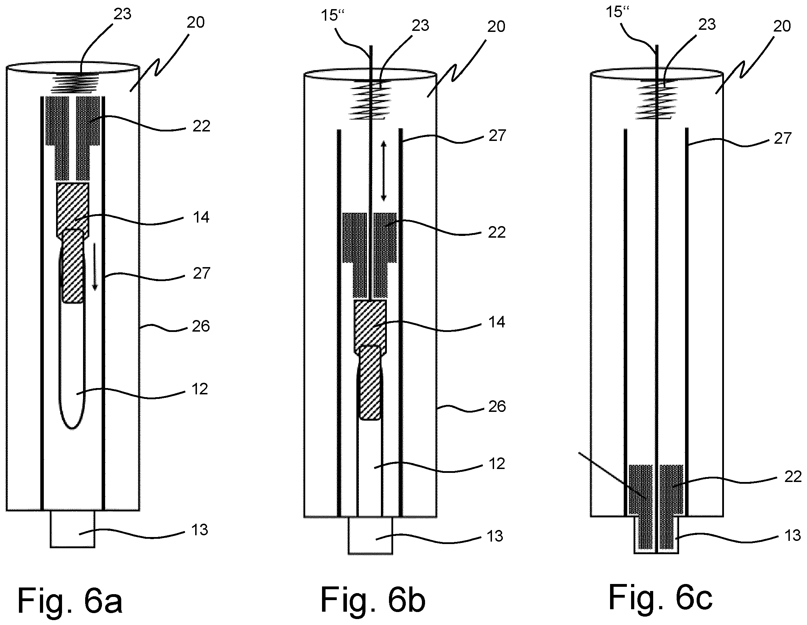

**Figures 6a to 6c** show schematic vertical cross sections through embodiments of the exchange station 20, namely
(a) in an upper position of the shuttle for opening,
(b) in an intermediate position of the shuttle, and
(c) in a closed position.

The changing station 20 is located at the upper end of the guide tube 13. Instead of a window 25 (as shown in Figure 3), the gas-tight exchange station 20 can comprise a door or a movable **sleeve 26** (as shown in Figures 6a and 6b) to access the shuttle assembly 14. This sleeve tube can be moved in the Z-direction and in a first position encloses the guide tube 13 in a gas-tight manner. The sleeve tube can be pushed into a second position, which gives access to the NMR sample container 12. In the area of the changing station 20, the guide tube 13 is designed to be half-open or extended by a semicircular guide so that the NMR sample container 12 can easily be removed.

It is also important that the shuttle assembly 14 is well centralized inside the guiding tube 13. For this purpose, a **centering device 22** is arranged on the upper end of the guide tube 13 for aligning the winch cord 15" inside the guide tube 13 as shown in Figure 6c. In the embodiment of figures 6 a-c, the centering device 22 is movable from the lower position in which the centering device is arranged in the guide tube 13. In this embodiment, the centering device is combined with a weight element for keeping the rope under tension when the shuttle assembly 14 travels inside the changing station 20 from the lower to the uppermost position where the resilient element (here spring 23) is arranged. The weight element is engaged to guide rails 27 for allowing a controlled movement of the shuttle assembly together with the centering device 22 and for a precise re-insertion of the centering device 22 inside the guide tube 13 after the NMR sample container 12 has been changed.. The main function of the centering device 22 is to perfectly axially center the rope in guide tube 13. There is no tilting moment of the shuttle due to non-axial rope force. This also prevents vibration, wear and free swing of the NMR sample container end protruding into the probehead.

The centering device 22 can also be attached separately from the weight element (not shown in figures 6) to the upper end of the guide tube 13 at the lower end of the exchange station. The centering device 22 also prevents vibration excitation at the guide tube 13 due to the fast movement of the shuttle assembly 14.

A stop for the shuttle assembly 14 is attached to the upper part of the guide tube 13, which is preferably pre-tensioned by a **spring 23,** so that the cord 15" remains under tension while the gas flow is interrupted.

**Guide rails 27** arranged within the exchange station 20 may also help to centralize the shuttle assembly 14 inside the guiding tube 13.

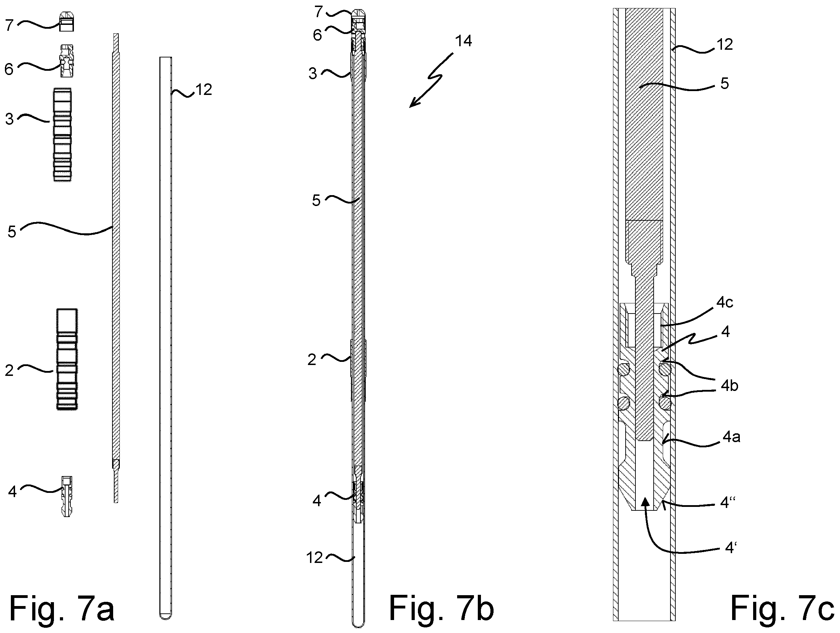

The embodiments depicted in **Figures 7a****-c** show a **shuttle assembly 14** according to the invention, namely (a) with all important parts shown separately, (b) with the parts of (a) in the assembled condition, and (c) an enhanced partial view of the lower portion of the shuttle assembly according (b). The shuttle assembly 14 comprises the following components:
NMR sample container 12, end stop part 2, bush part 3, plug 4, positioning rod 5, locking piece 6 and retainer 7.

The individual components shown in Fig. 7a have the following individual functions:
1) Precision NMR tube: The **NMR sample container 12** is a central part of the shuttle assembly 14, which is also a mechanical carrier for all other components. It is a high precision and low cost standard purchase part with a high bending stiffness, so there is only a small amplitude of the bending vibration. The components of the shuttle assembly 14 are simple parts that can being easily manufactured with high precision. They are glued or mounted to the NMR tube resulting in a highly precise assembly.
2) End stop sleeve: The end **stop part 2** is the first part of a guidance sleeve for the NMR sample container 12 in the guide tube 13. It determines the immersion depth of the NMR sample container 12 in the probe. In its design as a turned part, it allows fast, precise, low-cost manufacturing. The end stop sleeve is usually glued onto the NMR sample container 12.
3) Threaded sleeve: The **bush part 3** is the second guide sleeve of the NMR tube in the guide tube. The large distance to the end stop ensures precise guidance and low friction on the guide tube. Preferably, it comprises an internal thread for receiving the stopper. The threaded sleeve is preferably glued to the NMR tube too.

The sleeves 2 and 3 have an outer contour such that there is a tight clearance to the threaded sleeve, i.e. a small radial gap, which leads to precise guidance of the NMR tube, thus no tilting is possible. Optionally, axial grooves are incorporated (number 3 with 120° pitch), whereby the depth and width of the grooves are used to set the volume flow required to temper the shuttle (approx. 10Nl/min). Furthermore, turbulence generators can be imprinted. These are used for producing a chaotic turbulence of the air stream, without symmetry or periodicity. This prevents the occurrence of stable oscillatory states that cannot be terminated during operation. At the same time, it increases the shuttle's insensitivity to diameter tolerances and symmetry deviations due to manufacturing tolerances. The turbulence or vortex generators are designed as
- ring-shaped grooves with sharp edges of unequal width and spacing;
- groove segments with cutter cylindrical surface, unequally spaced on sleeves;
- spherical grooves milled radially with ball-end cutters; or
- other grooves and cutouts, transverse at an angle to longitudinal axes and other orientations on sleeves.

4) The **plug 4** limits the required filling quantity of the possibly very expensive NMR sample liquid and at the same time has the task of catching the bubbles in the sample that arise during rapid up and down movement of the shuttle so that they do not influence the NMR measurement. The plug 4 has the following components (from top to bottom). A **female thread 4c** for screwing to the positioning rod 5, **grooves 4b** for receiving gaskets, in particular for inserting O-ring seals 28, a circumferential **notch 4a** (constituting a bubble catcher) below the O-rings catching air bubbles (being a disturbance factor during measurement) and an axial **central bore 4'** for filling with sample liquid, e.g. via long cannula. The bore 4' is closed by the positioning rod 5 to prevent air entrapment in the bore. The large **chamfered outer surface 4"** of the plug 4 at the bottom causes the resulting air bubbles to move outward and upward. retainer 7.

5) The **positioning rod 5** fixes the plug 4 in its target position and closes the bore. It is also needed to pull the plug 4 out of the NMR tubes. At the upper end, the positioning rod 5 is clamped into the closure, e.g. with the help of a grub screw, to prevent it from oscillating and thus hitting the NMR tube, which would generate disturbing vibration.

6) The **locking piece 6** is screwed into the upper threaded sleeve 3. It encloses the knot from the rope and thus establishes the connection from the shuttle to the rope and motor.

7) The spherical **retainer 7** closes the openings in the locking piece 6 to the rope receptacle and thus ensures an even flow around the shuttle. In the embodiment shown in figures 7a and 7b, the retainer 7 is an optional feature and it can be combined with the locking piece 6 to a single part.

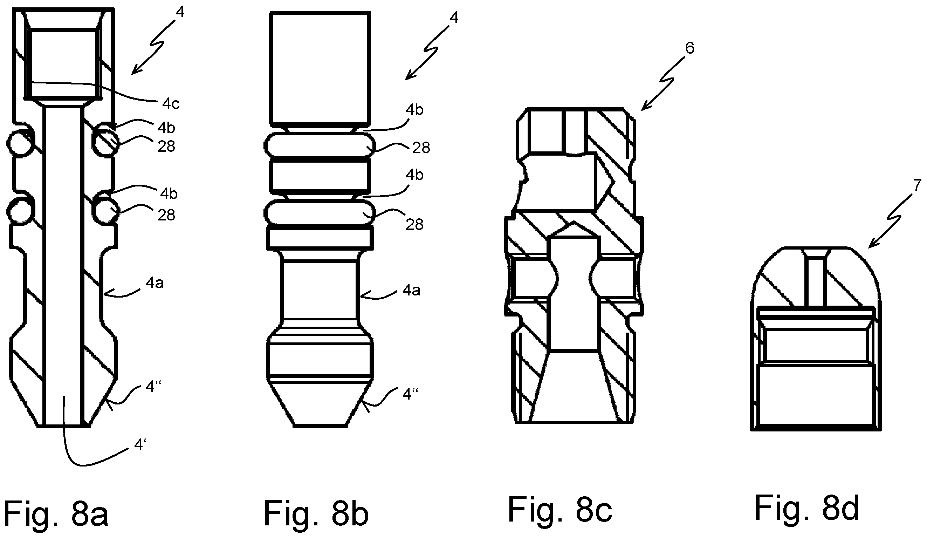

In **Figures 8a****-d** some of the important parts of the shuttle assembly already shown in Fig. 7b are depicted in greater detail.

**Fig. 8a** shows a vertical cross section of plug 4 for limiting the liquid NMR sample volume in the sample container 12 and taking effect as a bubble catcher. **Fig. 8b** depicts the plug 4 of Fig. 8a in a side view.

Said bubble catching plug 4 is positioned in the NMR sample container 12 with screwing the positioning rod 5 into a **female thread 4c** of plug 4 and O-rings 28 received in **grooves 4b** of plug 4. The bubble catching is performed by means of a **circumferential notch 4a** of the plug 4. Further, plug 4 has a **chamfered outer surface 4",** in particular of conical shape, at its lower end directing to the tip of the sample container 12 during operation of the spectrometer 10.

Procedure for filling the liquid NMR sample into the sample container 12:
i. The bubble catching plug 4 is pushed into position above the target position in the sample container 12 with the positioning rod 5 and O-rings 28 are applied.
ii. Sample liquid is filled into the NMR sample container 12 with a syringe until liquid passes through a **central bore 4'** of the plug 4.
iii. The rod 5 is pushed into the sample container 12, and the tip dips into central bore 4' and pushes air of bore 4' into the liquid overflow area.
iv. The rod 5 is used to push plug 4 into the end position, such that air and excess liquid is pushed past the O-rings 28 into the top of the sample container 12. Ideally, no air remains in the measurement area.
v. The excess liquid is removed from the upper area.

**Fig. 8c** depicts the locking piece 6 in a vertical cross section.

For fixation of the free end of the winch cord 15" to the shuttle assembly 14, the cord end is threaded through a small hole through the top portion of the locking piece 6 and knotted positively (so that the knot no longer fits through the hole). The locking piece 6 connected to the cord 15" later remains on the cord 15", so that only the locking piece 6 needs to be unscrewed when changing the sample container 12.

**Fig. 8d** shows an embodiment of the retainer 7 for being attached to the locking piece 6 of Fig. 8c also in a vertical cross section.

In the following embodiments of the invention, the NMR sample container 12 comprises means that serve as a turbine for spinning applications:

### Variant 1

The shuttle assembly 14 comprises internal plugs or retainers fixed around the NMR sample container 12 are connected to a cable suspension 15" in such a way that the cable suspension 15" attached to retainers form a sliding bearing with the locking piece and can thus rotate freely against each other. Preferably these are made of an appropriate material which has low friction values, such as Iglidur^{®}.

In the simplest case, the attachment of the cable 15" includes a retainer shaped as a **sliding washer 7a'** that has as little frictional resistance as possible to the

### locking piece 6'.

**Fig. 9a** shows a schematic vertical cross section through the upper part of an embodiment of the shuttle assembly 14 with a rotatable suspension for the NMR sample container 12 comprising a sliding washer 7a'.

Furthermore, it can be seen in Fig. 9a that the capping is made of two parts. It comprises a threaded sleeve in form of a bush part 3 which is force-fit or bonded to the NMR sample container 12. This could also be a plug which is fixed inside the sample container 12. Secondly, a closure in form of the locking piece 6' is screwed onto the threaded sleeve in which the sliding washer 7a' is arranged. The cable pull 15" is passed through an opening of the closure. The threaded sleeve 3 further comprises externally arranged **drive grooves 3a** which are helically arranged in the circumference of the sleeve 3. The compressed air arriving from above flows through the grooves 3a and causes the threaded sleeve 3 and the NMR sample container 12 to make a rotational movement.

**Fig. 9b** shows a schematic vertical cross section through the lower part of an embodiment of the shuttle assembly with a rotational bearing system comprising an end stop in form of a sliding cone.

The additional end stop sleeve 2 is attached to the lower part of the NMR sample container 12. In this embodiment, the end stop sleeve 2 is designed with a chamfer to form a stop surface (= **conical abutment surface 2a**) with an end stop 19 in form of a sliding cone having abutment surfaces 19' in the end stop position or rotational position of the NMR sample container 12, as shown in Fig. 9b. This helps also to center the NMR sample container 12 in the measurement position.

Further, a **circumferential outer surface 2b** of the guidance sleeve 2 (directed to a circumferential inner surface 13" of the guide tube 13 not shown in this figure) is contoured having small pits or grooves, preferably sharp edged, serving as vortex generators for providing a highly turbulent gas flow.

The above described variant 1 of the invention only works correctly when a rigid cord is used, which should be rigid enough to prevent to be twisted. However, since thin and thus easily twisted nylon cords are generally preferred, variants of the invention can include a mechanism by which it is possible to temporarily decouple the cord suspension from that in the retainer during the measurement, thus ensuring free rotation of the NMR sample container 12 without twisting the cord.

### Variant 2

One possibility for ensuring free rotation of the NMR sample container 12 without twisting the cord of the cable pull 15" is to place bearings (**nano- or microbearings 8**) between the **locking piece 6"**, which is firmly attached to the NMR sample container 12, and the non-rotating **retainer 7'; 7"** on which the cable is suspended. These bearings allow rotation of the NMR tube because the frictional resistance is lower than with the plain bearings. A rope or rod does not drill while the container is rotating. This design allows the use of a thinner cable pull.

**Fig. 10a** shows a schematic vertical cross section through the upper part of such an embodiment of a suspension for the shuttle assembly 14 comprising nano- or microbearings 8 between the locking piece 6" and the non-rotation retainer 7' on which a cable pull 15" is suspended, facilitating rotation of the NMR sample container 12 and decouple the suspension from the rotary motion.

**Fig. 10b** shows the embodiment of Fig. 10a inside the guide tube 13, however with an additional **O-ring rotational brake 7b** in the upper part of retainer 7".

### Variant 3

In addition or alternative to the bearings, a decoupling mechanism can be arranged which actively fixes the suspension and thus the cable pull 15" to the wall of the guide tube 13. The decoupling mechanism comprises a **spring biased element 9'; 9"** connected to clamping arms **9a'; 9a"**. In a normal state, i.e. when the opposing forces of the compressed air and the cable pull 15" are substantially equal, the spring element 9'; 9" causes the clamping arms 9a'; 9a" to be folded in. In a condition when the gas pressure is lowered, the arms 9a'; 9a" are unfolded under the spring bias and pressed against the guide tube 13. This causes the part of the shuttle system 14 that is connected to the pull cable 15" to be fixed against twisting. The brake system prevents the winch wire from being twisted when the sample is rotated. This condition is primarily achieved in the measuring position.

**Fig. 11a** shows a first exemplary embodiment of a suspension for the shuttle assembly 14 of the design with downward pivotable clamping arms 9a' in conjunction with a spring biased element 9' being part of a **retainer 7‴** dunking in a **locking piece 6‴**. The clamping position is triggered by a reduction in gas pressure. Due to the reduced gas pressure, the first component is pushed upwards by the spring, causing the clamping arms 9a' to slide outwards along the slanted edge.

**Fig. 11b** shows a second embodiment with upward pivotable clamping arms. Similar to the variant of Fig. 11a, the spring biased element 9" is arranged between the **retainer 7ʺʺ** dunking in the **locking piece 6ʺʺ.** However, here the clamping arms 9a" are directed upwards, so that - upon reduction of the applied gas pressure to the first component, the clamping arms 9a" are pressed outwards into the clamping position at a slope of the first component.

When the NMR sample container 12 is in the measuring position, it is rotated in the field of view. To drive the rotary motion compressed gas is used preferably. The sleeves attached to the outside of the NMR sample container 12 can be appropriately profiled for this purpose. In Figures 12a,b for example, a design is shown in which the sleeves are provided with helical grooves, like on a screw, through which the compressed air is passed. This helical path causes the NMR sample container 12 to perform a rotational movement.

**Fig. 12a** shows a part of an embodiment of the shuttle assembly 14 with an NMR sample container 12 comprising **sleeves 2', 3'** with helical thread profile for passing the compressed air.

**Fig. 12b** shows a top view on the embodiment of Fig. 12a.

The sleeves 2', 3' with helical grooves are serving as guides for the pressurized air that lead to rotation of the NMR sample container 12.

Alternatively, the sleeves may include a straight toothed profile, with a separate nozzle blowing compressed air at the toothed profile from a radial direction, causing the NMR sample container 12 to rotate.

**Fig. 13** shows such an embodiment of the shuttle assembly 14 with the NMR sample container 12 comprising an **upper sleeve 3"** and a **lower sleeve 2"** with a serrated profile and a **pressured gas supply 1** comprising a feed channel with radially arranged nozzle for compressed gas.

### List of reference signs:

- 1: pressured gas supply
- 2; 2'; 2": end stop part
- 2a: conical abutment surface
- 2b: circumferential outer surface of the guidance sleeve
- 3; 3'; 3": bush part
- 3a: drive grooves
- 2 + 3: guidance sleeve
- 4: plug
- 4': central bore of the plug
- 4": chamfered outer surface of the plug
- 4a: circumferential notch of the plug (bubble catcher)
- 4b: grooves for receiving gaskets
- 4c: female thread
- 5: rod
- 6; 6'; 6"; 6‴; 6ʺʺ: locking piece
- 7a': sliding washer
- 7; 7'; 7"; 7‴; 7ʺʺ: retainer
- 7b: O-ring rotational brake
- 8: nano- or microbearings
- 9'; 9": spring biased element
- 9a'; 9a": clamping arms
- 10: NMR spectrometer
- 11': high-field NMR magnet system
- 11": low-field NMR magnet system
- 12: NMR sample container
- 13: guide tube
- 13': drilled hole
- 13": circumferential inner surface of the guide tube
- 14: shuttle assembly
- 15': pulling drive
- 15": winch cord
- 16: entry for pressurized gas
- 17: gas-tight body
- 18: air gap
- 19: end stop
- 19', 19": abutment surfaces
- 20: gas-tight exchange station
- 21: dampening brackets
- 22: centering device
- 23: spring
- 24: holding element
- 25: window
- 26: movable sleeve of the gas-tight exchange station
- 27: guide rails
- 28: O-rings
- 30: detector element

### List of prior art citations:

[0] European Patent Application 21 167 449 not yet published at the date of this present application

Further publications considered for assessing patentability of the present invention:
[1] Andrew M.R. Hall et al, "A temperature-controlled sample shuttle for field-cycling NMR", Journal of Magnetic Resonance 317 (2020) 106778
[2] EP 3 081 954 B1
[3] Alfred G. Redfield, "Shuttling device for high-resolution measurements of relaxation and related phenomena in solution at low field, using a shared commercial 500 MHz NMR instrument", Magn. Reson. Chem. 2003; 41: 753-768
[4] Alfred G. Redfield, "High-resolution NMR field-cycling device for full-range relaxation and structural studies of biopolymers on a shared commercial instrument", J. Biomol NMR (2012) 52:159-177
[5] US 9,696,391 B2
[6] EP 2 610 631 B1
[7] US 4,859,949 A
[8] Patrick TomHon et al, "Automated pneumatic shuttle for magnetic cycling and parahydrogen hyperpolarized multidimensional NMR", Journal of Magnetic Resonance 312 (2020) 106700

## Claims

1. Shuttle assembly (14) designed and adapted for being arranged inside a guide tube (13) of an NMR spectrometer (10) with at least two coaxially arranged NMR magnet systems (11'; 11") and with a drive system for shuttling an NMR sample in the guide tube (13) between the NMR magnet systems (11'; 11"), the guide tube (13) being comprised in a transfer device and configured to be positioned in a central bore of the coaxial magnet systems (11'; 11"), wherein the shuttle assembly (14) comprises a sample container (12) for containing the NMR sample, wherein the shuttle assembly (14) has a piston design for enabling movement along the common axis of the coaxial magnet systems (11'; 11") under the influence of gas pressure generated by a pneumatic pressurizing arrangement being part of the transfer device, and wherein the shuttle assembly (14) comprises a plug (4) positioned in the sample container (12) for limiting the liquid NMR sample volume in the sample container (12) to an active volume area of the magnet systems (11'; 11") in an operational state of the spectrometer (10),
**characterized in**
**that** the plug (4) has a central bore (4') in axial direction for filling NMR sample material into the sample container (12), preferably by means of an injection needle, the bore (4') being closed by a rod (5), which is at least partly extending into the sample container (12) with its lower end.

2. Shuttle assembly according to claim 1, **characterized in that** it further comprises a guidance sleeve clasping around the sample container (12) in circumferential direction, in particular being glued on an outer surface of the sample container (12), for high precision alignment of the shuttle assembly (14) within the guide tube (13) in an operational state of the spectrometer (10).

3. Shuttle assembly according to claim 2, **characterized in that** the guidance sleeve comprises an end stop part (2; 2'; 2") near to the tip of the sample container (12) defining the immersion depth of the sample container (12) in a probe head of the spectrometer (10), the end stop part (2; 2'; 2") preferably having a conical abutment surface (2a) for axial and radial coupling to an end stop with protrusion for vibration dampening.

4. Shuttle assembly according to claim 3, **characterized in that** the guidance sleeve comprises a bush part (3; 3'; 3") near to the opening of the sample container (12), wherein the bush part (3; 3'; 3") and the end stop part (2; 2'; 2") having essentially the same diameter for ensuring precise guidance of the shuttle assembly (14) within the guide tube (13) in an operational state of the spectrometer (10), the bush part (3; 3'; 3") preferably having an internal screw thread for receiving a locking piece (6; 6'; 6"; 6"; 6ʺʺ).

5. Shuttle assembly according to anyone of claims 2 to 4, **characterized in that** a circumferential outer surface of the guidance sleeve directed to a circumferential inner surface (13") of the guide tube (13) is contoured having circumferential grooves (3a), preferably helical grooves for spinning the sample container (12) in a gas flow.

6. Shuttle assembly according to anyone of claims 2 to 4, **characterized in that** a circumferential outer surface (2b) of the guidance sleeve directed to a circumferential inner surface (13") of the guide tube (13) is contoured having small pits or grooves, preferably sharp edged, serving as vortex generators for providing a highly turbulent gas flow.

7. Shuttle assembly according to anyone of the preceding claims **characterized in that** the plug (4) has a chamfered outer surface (4"), in particular of conical shape, at its lower end directing to the tip of the sample container (12) during operation of the spectrometer (10), and a circumferential notch (4a) on its outer surface taking effect as a bubble catcher during operation of the spectrometer (10).

8. Shuttle assembly according to anyone of the preceding claims, **characterized in that** a retainer (7; 7'; 7"; 7‴; 7ʺʺ), in particular of spheroidal shape, is attached to a locking piece (6; 6'; 6"; 6"; 6""), the retainer (7; 7'; 7"; 7‴; 7"") also being attached to the drive system.

9. NMR spectrometer (10) with a shuttle assembly according to claim 8, with at least two coaxially arranged NMR magnet systems (11'; 11") and with a drive system for shuttling an NMR sample in the guide tube (13) between the NMR magnet systems (11'; 11"), the guide tube (13) being comprised in a transfer device and configured to be positioned in a central bore of the coaxial magnet systems (11'; 11"), the drive system comprising a winch cord (15") being attached to the retainer (7; 7'; 7"; 7‴; 7ʺʺ) of the shuttle assembly (14), and that the retainer (7; 7'; 7"; 7‴; 7"") and the locking piece (6; 6'; 6"; 6"; 6ʺʺ) being slidably attached to each other for forming a decoupling mechanism for rotatably decoupling the sample container (12) from the winch cord (15") in an operational state.

10. NMR spectrometer (10) according to claim 9, **characterized in that** the decoupling mechanism comprises nano- or microbearings (8) placed between the locking piece (6"), which is firmly attached to the sample container (12) and the non-rotating retainer (7'; 7") on which the winch cord (15") is suspended, the nano- or microbearings (8) being designed to allow for rotation of the sample container (12), whereby the winch cord (15") is not drilled.

11. NMR spectrometer (10) according to claim 9 or 10, **characterized in that** the decoupling mechanism of the retainer (7‴; 7ʺʺ) comprises a braking system with a spring biased element (9'; 9") connected to clamping arms (9a'; 9a"), wherein in a first operational state, when the opposing forces of the gas pressure generated by the pneumatic pressurizing arrangement and the pulling force generated by the pulling drive (15') are substantially equal, the spring biased element (9'; 9") causes the clamping arms (9a'; 9a") to be folded in, whereas in a second operational state, when the gas pressure is lowered, the clamping arms (9a'; 9a") are unfolded under the spring bias of element (9'; 9") and pressed against the guide tube (13).

12. NMR spectrometer (10) according to anyone of claims 9 to 11, **characterized in that** the transfer device comprises a pulling drive (15') and a winch cord (15") being attached to said drive system on one side and to the shuttle assembly (14) on the other side, wherein the pulling drive (15') of said drive system preferably comprises a cable winch, which is equipped with a rotating mechanism, and that the transfer device comprises a gas-tight body (17) above the shuttle assembly (14) and a pneumatic pressurizing arrangement with an entry (16) for pressurized gas arranged on the gas-tight body (17) for maintaining the winch cord (15") under tension.

13. NMR spectrometer (10)according to claim 12, **characterized in that** an air gap (18) is provided between the shuttle piston and the inner wall of the guide tube (13) and that a gas-tight exchange station (20) comprises a window (25), a movable sleeve (26) or a door to access the shuttle assembly (14).

## Patentansprüche

1. Shuttle-Anordnung (14), konzipiert und geeignet zur Anordnung innerhalb eines Führungsrohrs (13) eines NMR-Spektrometers (10) mit mindestens zwei koaxial angeordneten NMR-Magnetsystemen (11'; 11") und mit einem Antriebssystem zum Verschieben einer NMR-Probe in dem Führungsrohr (13) zwischen den NMR-Magnetsystemen (11'; 11"), wobei das Führungsrohr (13) in einer Transfervorrichtung enthalten ist und so konfiguriert ist, dass es in einer zentralen Bohrung der koaxialen Magnetsysteme (11'; 11") positioniert werden kann, wobei die Shuttle-Anordnung (14) einen Probenbehälter (12) zur Aufnahme der NMR-Probe umfasst, wobei die Shuttle-Anordnung (14) eine Kolbenkonstruktion aufweist zum Aktivieren einer Bewegung entlang der gemeinsamen Achse der koaxialen Magnetsysteme (11'; 11") unter dem Einfluss von Gasdruck, der durch eine pneumatische Anordnung zur Druckbeaufschlagung erzeugt wird, die Teil der Transfervorrichtung ist, und wobei die Shuttle-Anordnung (14) einen Stopfen (4) umfasst, der in dem Probenbehälter (12) positioniert ist, um das flüssige NMR-Probenvolumen in dem Probenbehälter (12) auf einen aktiven Volumenbereich der Magnetsysteme (11'; 11") in einem Betriebszustand des Spektrometers (10) einzuschränken,
**dadurch gekennzeichnet, dass**
der Stopfen (4) eine zentrale Bohrung (4') in axialer Richtung zum Einfüllen von NMR-Probenmaterial in den Probenbehälter (12), vorzugsweise mittels einer Injektionsnadel, aufweist, wobei die Bohrung (4') durch einen Stab (5) verschlossen ist, der mit seinem unteren Ende mindestens teilweise in den Probenbehälter (12) hineinragt.

2. Shuttle-Anordnung nach Anspruch 1, **dadurch gekennzeichnet, dass** sie ferner eine Führungshülse umfasst, die den Probenbehälter (12) in Umfangsrichtung umklammert, insbesondere auf eine Außenfläche des Probenbehälters (12) geklebt ist, zur hochpräzisen Ausrichtung der Shuttle-Anordnung (14) innerhalb des Führungsrohrs (13) in einem Betriebszustand des Spektrometers (10).

3. Shuttle-Anordnung nach Anspruch 2, **dadurch gekennzeichnet, dass** die Führungshülse einen Endanschlagteil (2; 2'; 2") nahe der Spitze des Probenbehälters (12) umfasst, der die Eintauchtiefe des Probenbehälters (12) in einen Probenkopf des Spektrometers (10) definiert, wobei der Endanschlagteil (2; 2'; 2") vorzugsweise eine konische Anschlagfläche (2a) zum axialen und radialen Koppeln an einen Endanschlag mit Vorsprung zur Schwingungsdämpfung aufweist.

4. Shuttle-Anordnung nach Anspruch 3, **dadurch gekennzeichnet, dass** die Führungshülse einen Buchsenteil (3; 3'; 3") nahe der Öffnung des Probenbehälters (12) umfasst, wobei der Buchsenteil (3; 3'; 3") und der Endanschlagteil (2; 2'; 2") im Wesentlichen den gleichen Durchmesser aufweisen, um eine präzise Führung der Shuttle-Anordnung (14) innerhalb des Führungsrohrs (13) in einem Betriebszustand des Spektrometers (10) sicherzustellen, wobei der Buchsenteil (3; 3'; 3") vorzugsweise ein Innengewinde zur Aufnahme eines Verriegelungsstücks (6; 6'; 6"; 6"; 6"") aufweist.

5. Shuttle-Anordnung nach einem der Ansprüche 2 bis 4,
**dadurch gekennzeichnet, dass** eine äußere Umfangsfläche der Führungshülse, die auf eine innere Umfangsfläche (13") des Führungsrohrs (13) gerichtet ist, konturiert ist und Umfangsnuten (3a), vorzugsweise spiralförmige Nuten, zum Drehen des Probenbehälters (12) in einer Gasströmung aufweist.

6. Shuttle-Anordnung nach einem der Ansprüche 2 bis 4,
**dadurch gekennzeichnet, dass** eine äußere Umfangsfläche (2b) der Führungshülse, die zu einer inneren Umfangsfläche (13") des Führungsrohrs (13) gerichtet ist, konturiert ist und kleine, vorzugsweise scharfkantige, Vertiefungen oder Nuten aufweist, die als Wirbelgeneratoren zum Bereitstellen einer hochturbulenten Gasströmung dienen.

7. Shuttle-Anordnung nach einem der vorhergehenden Ansprüche,
**dadurch gekennzeichnet, dass** der Stopfen (4) eine abgeschrägte Außenfläche (4"), insbesondere mit konischer Form, an seinem unteren Ende aufweist, die während des Betriebs des Spektrometers (10) auf die Spitze des Probenbehälters (12) leitet, und eine umlaufende Kerbe (4a) an seiner Außenfläche aufweist, die während des Betriebs des Spektrometers (10) als Blasenfänger wirkt.

8. Shuttle-Anordnung nach einem der vorhergehenden Ansprüche,
**dadurch gekennzeichnet, dass** ein Halter (7; 7'; 7"; 7"; 7""), insbesondere in kugeliger Form, an einem Verriegelungsstück (6; 6'; 6"; 6"; 6"") angebracht ist, wobei der Halter (7; 7'; 7"; 7"; 7"") auch an dem Antriebssystem angebracht ist.

9. NMR-Spektrometer (10) mit einer Shuttle-Anordnung nach Anspruch 8, mit mindestens zwei koaxial angeordneten NMR-Magnetsystemen (11'; 11") und mit einem Antriebssystem zum Verschieben einer NMR-Probe in dem Führungsrohr (13) zwischen den NMR-Magnetsystemen (11'; 11"), wobei das Führungsrohr (13) in einer Transfervorrichtung enthalten ist und so konfiguriert ist, dass es in einer zentralen Bohrung der koaxialen Magnetsysteme (11'; 11") positioniert werden kann, das Antriebssystem umfassend ein Windenseil (15"), das an dem Halter (7; 7'; 7"; 7‴; 7"") der Shuttle-Anordnung (14) angebracht ist, und dass der Halter (7; 7'; 7"; 7"; 7ʺʺ) und das Verriegelungsstück (6; 6'; 6"; 6"; 6ʺʺ) verschiebbar aneinander angebracht sind, um einen Entkopplungsmechanismus zum rotierbaren Entkoppeln des Probenbehälters (12) von dem Windenseil (15") in einem Betriebszustand zu bilden.

10. NMR-Spektrometer (10) nach Anspruch 9, **dadurch gekennzeichnet, dass** der Entkopplungsmechanismus Nano- oder Mikrolager (8) umfasst, die zwischen dem Verriegelungsstück (6"), das fest an dem Probenbehälter (12) angebracht ist, und dem nicht rotierbaren Halter (7'; 7"), an dem das Windenseil (15") aufgehängt ist, angeordnet sind, wobei die Nano- oder Mikrolager (8) so konzipiert sind, dass sie eine Rotation des Probenbehälters (12) ermöglichen, wodurch das Windenseil (15") nicht verdrillt wird.

11. NMR-Spektrometer (10) nach Anspruch 9 oder 10,
**dadurch gekennzeichnet, dass** der Entkopplungsmechanismus des Halters (7‴; 7"") ein Bremssystem mit einem federvorgespannten Element (9'; 9") umfasst, das mit Klemmarmen (9a'; 9a") verbunden ist, wobei in einem ersten Betriebszustand, wenn die entgegengesetzten Kräfte des Gasdrucks, der durch die pneumatische Anordnung zur Druckbeaufschlagung erzeugt wird, und der Zugkraft, die durch den Zugantrieb (15') erzeugt wird, im Wesentlichen gleich sind, das federvorgespannte Element (9'; 9") ein Einklappen der Klemmarme (9a'; 9a") bewirkt, während in einem zweiten Betriebszustand, wenn der Gasdruck abgesenkt wird, die Klemmarme (9a'; 9a") unter der Federvorspannung des Elements (9'; 9") ausgeklappt und gegen das Führungsrohr (13) gedrückt werden.

12. NMR-Spektrometer (10) nach einem der Ansprüche 9 bis 11,
**dadurch gekennzeichnet, dass** die Transfervorrichtung einen Zugantrieb (15') und ein Windenseil (15") umfasst, das an dem Antriebssystem auf einer Seite und der Shuttle-Anordnung (14) auf der anderen Seite angebracht ist, wobei der Zugantrieb (15') des Antriebssystems vorzugsweise ein Windenseil umfasst, das mit einem Rotationsmechanismus ausgestattet ist, und dass die Transfervorrichtung einen gasdichten Körper (17) oberhalb der Shuttle-Anordnung (14) und eine pneumatische Anordnung zur Druckbeaufschlagung mit einem Eint (16) für Druckgas umfasst, der an dem gasdichten Körper (17) angeordnet ist, um das Windenseil (15") unter Spannung zu halten.

13. NMR-Spektrometer (10) nach Anspruch 12,
**dadurch gekennzeichnet, dass** zwischen dem Shuttle-Kolben und der Innenwand des Führungsrohrs (13) ein Luftspalt (18) vorhanden ist, und dass eine Gas-dichte Wechselstation (20) ein Fenster (25), eine bewegbare Hülse (26) oder eine Tür für den Zugang zu der Shuttle-Anordnung (14) umfasst.

## Revendications

1. Ensemble navette (14) conçu et adapté pour être agencé à l'intérieur d'un tube de guidage (13) d'un spectromètre RMN (10) muni d'au moins deux systèmes d'aimant RMN agencés de façon coaxiale (11' ; 11") et muni d'un système d'entraînement pour faire faire la navette à un échantillon RMN à l'intérieur du tube de guidage (13) entre les systèmes d'aimant RMN agencés de façon coaxiale (11' ; 11"), le tube de guidage (13) étant compris à l'intérieur d'un dispositif de transfert et étant configuré pour être positionné à l'intérieur d'un alésage central des systèmes d'aimant RMN agencés de façon coaxiale (11' ; 11"),
dans lequel l'ensemble navette (14) comprend un moyen de contenance d'échantillon (12) pour contenir l'échantillon RMN, dans lequel l'ensemble navette (14) comporte une configuration de piston pour permettre un déplacement suivant l'axe commun des systèmes d'aimant RMN agencés de façon coaxiale (11'; 11") sous l'influence d'une pression de gaz qui est générée par un agencement de mise sous pression pneumatique qui est une partie du dispositif de transfert, et dans lequel l'ensemble navette (14) comprend un tampon (4) qui est positionné à l'intérieur du moyen de contenance d'échantillon (12) pour limiter le volume d'échantillon RMN liquide à l'intérieur du moyen de contenance d'échantillon (12) sur une aire volumique active des systèmes d'aimant RMN agencés de façon coaxiale (11 ; 11") dans un état opérationnel du spectromètre RMN (10),
**caractérisé en ce que** :
le tampon (4) comprend un alésage central (4') dans une direction axiale pour remplir le matériau d'échantillon RMN à l'intérieur du moyen de contenance d'échantillon (12), de préférence au moyen d'une aiguille d'injection, l'alésage (4') étant fermé par une tige (5), laquelle tige est étendue au moins partiellement à l'intérieur du moyen de contenance d'échantillon (12) avec son extrémité inférieure.

2. Ensemble navette selon la revendication 1, **caractérisé en ce qu'**il comprend en outre une manchette de guidage qui est serrée autour du moyen de contenance d'échantillon (12) dans une direction circonférentielle, en particulier qui est collée sur une surface externe du moyen de contenance d'échantillon (12), dans le but d'un alignement haute précision de l'ensemble navette (14) à l'intérieur du tube de guidage (13) dans un état opérationnel du spectromètre RMN (10).

3. Ensemble navette selon la revendication 2, **caractérisé en ce que** la manchette de guidage comprend une partie d'élément d'arrêt d'extrémité (2 ; 2'; 2") à proximité de la pointe du moyen de contenance d'échantillon (12), laquelle partie définit la profondeur d'immersion du moyen de contenance d'échantillon (12) à l'intérieur d'une tête de sonde du spectromètre RMN (10), la partie d'élément d'arrêt d'extrémité (2 ; 2'; 2") comportant de préférence une surface de venue en butée conique (2a) pour un couplage axial et radial sur un élément d'arrêt d'extrémité muni d'une protubérance pour amortir les vibrations.

4. Ensemble navette selon la revendication 3, **caractérisé en ce que** la manchette de guidage comprend une partie de douille (3 ; 3'; 3") à proximité de l'ouverture du moyen de contenance d'échantillon (12), dans lequel la partie de douille (3 ; 3'; 3") et la partie d'élément d'arrêt d'extrémité (2 ; 2' ; 2") présentent essentiellement le même diamètre pour assurer un guidage précis de l'ensemble navette (14) à l'intérieur du tube de guidage (13) dans un état opérationnel du spectromètre RMN (10), la partie de douille (3 ; 3'; 3") comportant de préférence un filet de vissage interne ou taraudage pour recevoir une pièce de blocage (6 ; 6'; 6"; 6‴ ; 6"").

5. Ensemble navette selon l'une quelconque des revendications 2 à 4, **caractérisé en ce qu'**une surface externe circonférentielle de la manchette de guidage qui est dirigée en direction d'une surface interne circonférentielle (13") du tube de guidage (13) est profilée de telle sorte qu'elle comporte des rainures circonférentielles (3a), de préférence des rainures hélicoïdales pour faire tourner le moyen de contenance d'échantillon (12) à l'intérieur d'un flux de gaz.

6. Ensemble navette selon l'une quelconque des revendications 2 à 4, **caractérisé en ce qu'**une surface externe circonférentielle (2b) de la manchette de guidage qui est dirigée en direction d'une surface interne circonférentielle (13") du tube de guidage (13) est profilée de telle sorte qu'elle comporte des petits trous ou des petites rainures, de préférence présentant un bord tranchant, qui jouent le rôle de générateurs de vortex pour assurer un écoulement de gaz hautement turbulent.

7. Ensemble navette selon l'une quelconque des revendications précédentes, **caractérisé en ce que** le tampon (4) comporte une surface externe chanfreinée (4"), en particulier de forme conique, au niveau de son extrémité inférieure qui est dirigée en direction de la pointe du moyen de contenance d'échantillon (12) pendant le fonctionnement du spectromètre RMN (10), et une encoche circonférentielle (4a) sur sa surface externe qui joue le rôle de capteur et receveur de bulles pendant le fonctionnement du spectromètre RMN (10).

8. Ensemble navette selon l'une quelconque des revendications précédentes, **caractérisé en ce qu'**un moyen de retenue (7 ; 7'; 7"; 7‴ ; 7""), en particulier de forme sphéroïdale, est lié à une pièce de blocage (6 ; 6'; 6"; 6‴ ; 6""), le moyen de retenue (7 ; 7'; 7"; 7‴ ; 7"") étant également lié au système d'entraînement.

9. Spectromètre RMN (10) muni d'un ensemble navette selon la revendication 8, muni d'au moins deux systèmes d'aimant RMN agencés de façon coaxiale (11' ; 11") et muni d'un système d'entraînement pour faire faire la navette à un échantillon RMN à l'intérieur du tube de guidage (13) entre les systèmes d'aimant RMN agencés de façon coaxiale (11' ; 11"), le tube de guidage (13) étant compris à l'intérieur d'un dispositif de transfert et étant configuré pour être positionné à l'intérieur d'un alésage central des systèmes d'aimant RMN agencés de façon coaxiale (11'; 11"), le système d'entraînement comprenant un cordon de treuil (15") qui est lié au moyen de retenue (7 ; 7'; 7" ; 7"' ; 7"") de l'ensemble navette (14), et le moyen de retenue (7 ; 7'; 7"; 7"' ; 7"") et la pièce de blocage (6 ; 6'; 6"; 6"' ; 6"") étant liés de façon coulissante l'un à l'autre pour former un mécanisme de découplage pour découpler le moyen de contenance d'échantillon (12) vis-à-vis du cordon de treuil (15") dans un état opérationnel.

10. Spectromètre RMN (10) selon la revendication 9, **caractérisé en ce que** le mécanisme de découplage comprend des nano-paliers ou des micro-paliers (8) qui sont placés entre la pièce de blocage (6"), laquelle est liée fermement au moyen de contenance d'échantillon (12), et le moyen de retenue en non rotation (7'; 7") sur lequel le cordon de treuil (15") est suspendu, les nano-paliers ou micro-paliers (8) étant conçus pour permettre la rotation du moyen de contenance d'échantillon (12), d'où il résulte que le cordon de treuil (15") n'est pas percé.

11. Spectromètre RMN (10) selon la revendication 9 ou 10, **caractérisé en ce que** le mécanisme de découplage du moyen de retenue (7"' ; 7"") comprend un système de freinage muni d'un élément de sollicitation par poussée à ressort (9' ; 9") qui est connecté à des bras de préhension et de serrage (9a' ; 9a"), dans lequel, dans un premier état opérationnel, lorsque les forces opposées de la pression de gaz qui est générée par l'agencement de mise sous pression pneumatique et de la force de traction qui est générée par le moyen d'entraînement par traction (15') sont sensiblement égales, l'élément de sollicitation par poussée à ressort (9'; 9") a pour effet que les bras de préhension et de serrage (9a' ; 9a") sont repliés, tandis que dans un second état opérationnel, lorsque la pression de gaz est abaissée, les bras de préhension et de serrage (9a'; 9a") sont dépliés sous l'effet de la sollicitation par poussée de l'élément de sollicitation par poussée à ressort (9'; 9") et sont pressés contre le tube guidage (13).

12. Spectromètre RMN (10) selon l'une quelconque des revendications 9 à 11, **caractérisé en ce que** le dispositif de transfert comprend un moyen d'entraînement par traction (15') et un cordon de treuil (15") qui sont liés audit système d'entraînement sur un côté et à l'ensemble navette (14) sur l'autre côté, dans lequel le moyen d'entraînement par traction (15') dudit système d'entraînement comprend de préférence un treuil à câble, lequel est muni d'un mécanisme d'entraînement en rotation, et **en ce que** le dispositif de transfert comprend un corps étanche au gaz (17) au-dessus de l'ensemble navette (14) et un agencement de mise sous pression pneumatique muni d'une entrée (16) pour le gaz sous pression en une position sur le corps étanche au gaz (17) pour maintenir le cordon de treuil (15") sous tension.

13. Spectromètre RMN (10) selon la revendication 12, **caractérisé en ce qu'**un espace d'air (18) est prévu entre le piston de navette et la paroi interne du tube de guidage (13) et **en ce qu'**une station d'échange étanche au gaz (20) comprend une fenêtre (25), une manchette mobile (26) ou une porte pour accéder à l'ensemble navette (14).
